# EUROPÄISCHE PATENTSCHRIFT

(11) **EP 2 062 300 B1**
(45) Veröffentlichungstag und Bekanntmachung des Hinweises auf die Patenterteilung: **30.09.2015**
(21) Anmeldenummer: 07817456.2
(22) Anmeldetag: 28.08.2007
(51) Int. Cl.: H01L 31/18

(54) **LOKALE HETEROSTRUKTURKONTAKTE**
LOCAL HETEROSTRUCTURE CONTACTS
CONTACTS LOCAUX À HÉTÉROSTRUCTURE

(30) Priorität: 05.09.2006 DE 102006042617
(43) Veröffentlichungstag der Anmeldung: 27.05.2009
(73) Patentinhaber: CSEM Centre Suisse d'Electronique et de Microtechnique-Recherche et Développement, 2002 Neuchatel (CH)
(72) Erfinder: FAHRNER, Wolfgang, Rainer, 58097 Hagen (DE)
(74) Vertreter: GLN SA
(86) Internationale Anmeldenummer: PCT/DE2007/001532
(87) Internationale Veröffentlichungsnummer: WO 2008/040273

(56) Entgegenhaltungen:
- DE-A1- 19 819 200
- DE-A1-102004 061 604
- US-A1- 2006 130 891
- METZ A ET AL: "Record efficiencies above 21% for MIS-contacted diffused junction silicon solar cells" CONFERENCE RECORD OF THE 26TH IEEE PHOTOVOLTAIC SPECIALISTS CONFERENCE, 29. September 1997 (1997-09-29), Seiten 283-286, XP010267782 ISBN: 0-7803-3767-0
- ULYASHIN A ET AL COMMISSION OF THE EUROPEAN COMMUNITIES: "LOW-TEMPERATURE DRIFT FIELD PERFORMANCE IN THE BASE REGION OF CRYSTALLINE SILICON SOLAR CELLS BY HYDROGEN ENHANCED THERMAL DONOR FORMATION" 17TH. E.C. PHOTOVOLTAIC SOLAR ENERGY CONFERENCE. MUNICH, GERMANY, OCT. 22 - 26, 2001, PROCEEDINGS OF THE INTERNATIONAL PHOTOVOLTAIC SOLAR ENERGY CONFERENCE, MUNICH : WIP-RENEWABLE ENERGIES, DE, Bd. VOL. 2 OF 3. CONF. 17, 22. Oktober 2001 (2001-10-22), Seiten 1379-1382, XP001139701 ISBN: 3-936338-08-6 in der Anmeldung erwähnt

## Beschreibung

### Umfeld und Stand der Technik:

### 1.1 Herkömmliche Solarzellen :

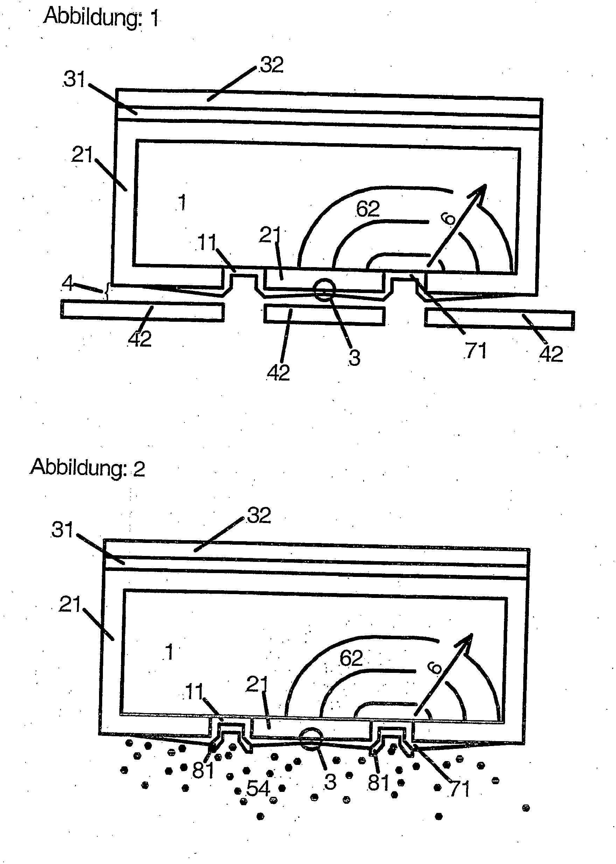

Herkömmliche Solarzellen (Abb. 1. in [Goetzberger03]) aus Halbleitermaterialien (vornehmlich Silizium) sind so aufgebaut, dass die durch Licht erzeugten Ladungsträger von einander getrennt werden, bevor sie wieder miteinander rekombinieren können. Dies erreicht man i.d.R. mittels eines pn-Überganges (Eine p- und eine n-leitende Schicht werden in Kontakt gebracht. Dadurch entsteht ein die Ladungsträger trennendes elektrisches Feld). Um die voneinander getrennten Ladungsträger aus der p- bzw. n-Schicht nach außen abzuführen und so elektrisch nutzbar zu machen, muss auf beiden Schichten je ein elektrischer Kontakt angebracht werden, der möglichst geringe Verluste veru2rsacht. Alle verbleibenden Oberflächen des Halbleiters müssen so behandelt sein, dass an ihnen nur sehr geringe Rekombination stattfindet. Sie müssen passiviert sein.

### 1.2 Hochleistungs-Silizium-Solarzellen :

Bei Hochleistungs-Silizium-Solarzellen sind beide Prämissen (guter Kontakt und gute Oberflächenpassivierung) sehr gut gelöst. Es existieren verschiedene Konzepte mit jeweiligen Variationen (auf die nicht im Detail eingegangen wird):
1. Die PERL-Zellen (*Passivated Emitter Rear Locally Diffused*) (Abb. 1 in [Green98]) weisen große passivierte Flächen und kleine Basis- Kontaktflächen auf der Rückseite auf. Unter den Kontaktflächen ist das Siliziummaterial hoch dotiert. An den diffundierten Kontaktflächen tritt immer die unerwünschte Rekombination auf, auch wenn die Fläche extra klein ausgeführt ist. Zur Erstellung solcher Zellen sind folgende Prozessschritte. nötig:
   - Eine ganzflächige Oberflächenpassivierung (SiO₂, SiNₓ:H, a-Si:H, a-SiC:H, Floating Junction, ...) wird erzeugt.
   - An den späteren Kontaktstellen der Basis wird diese Oberflächenpassivierung lokal geöffnet (zunächst maskiert mittels Photolithographie und anschließendem Ätzen, nasschemisch, Laserablation, mechanisch, ...).
   - Metalle werden mit unterschiedlichen Verfahren (Aufdampfen, Sputtern, Abscheiden aus der flüssigen Phase, Siebdruck mit Pasten, ...) aufgebracht. Um sehr niedrige Kontaktwiderstände zu erhalten, wird unter den Kontaktstellen zuvor hoch dotiert. Das Metall wird wie oben beschrieben abgeschieden und gegebenenfalls anschließend das überschüssige Metall beseitigt (Lift-Off-Verfahren).
2. Das LFC-Verfahren (*Laser Fired Contacts,* Abb. 1 in [Glunz04]) verwendet auf dem Siliziumsubstrat eine ganzflächig passivierende, elektrisch nicht leitende Schicht. Darauf wird eine Metallschicht ganzflächig abgeschieden. Diese Doppelschicht wird mittels Laser lokal aufgeschmolzen und dadurch kontaktiert. Die nicht geschmolzenen Flächen behalten ihre passivierende Wirkung.
3. COSIMA-Verfahren *(Contacts* to *the a-Si-Passivated Surfaces by means of Annealing,* Abb. 1 in [Plagwitz05]) verwendet eine ganzflächige Passivierung aus amorphem Silizium (a-Si:H), auf das lokal Aluminium aufgedampft wird. Durch Aufheizen entsteht unter dem Aluminium eine elektrisch gut leitende, hoch mit Aluminium dotierte Silizium-Schicht. Die Flächen, auf die zuvor kein Aluminium aufgebracht wurde, passivieren weiterhin die nicht kontaktierten Flächen.
4. Bei Heterojunction- [Schmidt06] und HIT-(*Heterojunction with Intrinsic Thin Layer,* Abb. 1 in [Maruyama06]) Solarzellen sind die Kontaktflächen so groß wie eine Substratvorder- oder Rückseite. Die Heterostrukturen dieser Solarzellen bilden nicht nur einen guten Kontakt, sondern halten auch gleichzeitig die Rekombination an der Kontaktfläche extrem gering.
5. Bei IBC (*Interdigitated Back Contacts) -* Rückkontakt-Solarzellen (Abb. 1 in [Mulligan04]) sind die Emitter- und Basiskontakte beide auf der SolarzellenRückseite angeordnet, um Verschattungsverluste durch Gridfinger und Sammelbusse (diese bedecken sonst bis zu 8 % der Solarzellen-Oberfläche) zu vermeiden.

### 1.2.1 Nachteile bei den oben genannten Verfahren:

### Zu 1.:

- Das lokale Öffnen der Passivierungsschicht ist:
   ∘ mit Photolithographie sehr aufwendig, die Chemikalien sind teuer und es fallen viele Abmedien an. Dementsprechend teuer ist das Verfahren.
   ∘ mit Laserablation durch hohe Investitions- und laufende Kosten (Lampen, Kühlung) auch teuer.
   ∘ mechanisch durch Schädigung der Oberfläche gekennzeichnet. Dadurch entstehen höhere Rekömbinationsverluste am späteren Kontakt.
- Das lokale Dotieren unter den späteren Kontaktstellen ist aufwendig und teuer. An den Kontakten tritt Rekombination auf (Sättigungsströme J₀ > 1000 fA/cm²).
- In den hochdotierten Bereichen (ab ∼10¹⁷ cm⁻³) tritt Absorption durch freie Ladungsträger auf, die zu Stromverlusten führt.

### Zu 2.:

- Das lokale Aufschmelzen des Siliziums kann zu starken Spannungen und Kristallschäden führen, die Verlusten hervorrufen.
- An den Kontakten tritt Rekombination auf (Sättigungsströme J₀ > 1000 fA/cm²).
- In den hochdotierten Bereichen (ab ∼10¹⁷ cm⁻³) tritt Absorption durch freie Ladungsträger auf, die zu Stromverlusten führt.
- Es treten hohe Investitions- (Laser) und laufende Kosten (Lampen, Kühlung) auf.

### Zu 3.:

- Der COSIMA-Kontakt liefert hohe Kontaktwiderstände.
- Das Aluminium muss lokal aufgedampft werden. Dies ist aufwendig und teuer.
- Der Kontakt funktioniert nur auf p-Typ Silizium.

### Zu 4..

Der Heteroübergang an der dem Licht zugewandten Seite muss Materialeigenschaften aufweisen, die gleichzeitig mehrere Aufgaben erfüllen. Dies macht die Prozessfindung und -führung extrem schwierig. Der Heteroübergang muss:
1. die Waferoberfäche sehr gut passivieren,
2. hoch dotiert sein,
3. gut elektrisch leitfähig sein,
4. eine geringe Absorption aufweisen (Dies gilt für den Emitter wie auch das TCO (Transparent Conductive Oxide)),
5. eine geringe Defektdichte aufweisen,
6. sehr dünn sein (ca. 5 nm),
7. eine geringe Oberflächenrauhigkeit aufweisen,
8. in der Fläche eine homogene Schichtdicke aufweisen,
9. und einen guten Kotakt zum TCO aufweisen.

Diese Anforderungen widersprechen sich teilweise. Es sind daher zum Teil nur Kompromisse der Eigenschaften möglich.

### Zu 5.:

Bei der Rückkontaktzelle wird die lokale Kontaktstruktur mittels Photolithographie oder druckfähigen Dotierpasten und anschließenden Diffusionsprozessen erzeugt. Dies ist einerseits aufwendig und teuer, andererseits sind die Verluste an den diffundierten Kontaktpunkten mit einer hohen Rekombination verbunden (Sättigungsströme J₀ > 1000 fA/cm²).

Allgemein lässt sich sagen, dass diffundierte Kontakte gegenüber Heterokontakten ca. 40-fach höhere Sättigungsströme [Swanson05] aufweisen. Dadurch sinkt das mögliche Spannungs- und auch Leistungsniveau. Außerdem sind bei HIT-Solarzellen die leistungsbezogenen Temperaturkoeffizienten wesentlich niedriger (-0,25 %/°C) als bei herkömmlichen Solarzellen (-0,45 %/°C) oder Hochleistungs-Rückkontakt-Solarzellen (-0,38 %/°C) [Taguchi05]. Dies führt zu höheren Ehergieerträgen bei steigenden Solarzellen-Betriebstemperaturen. Gegenüber den 25 °C der *Standard Test Conditions* (STC) steigen die Zelltemperaturen im Sommer bei voller Einstrahlung, also größten Erträgen, auf über 80 °C. Dies macht sich im Jahresertrag deutlich bemerkbar.
Andererseits treten bei den HIT-Solarzellen etwa 7 - 8 % Verschattungsverluste durch die Gridfinger und Busbars auf.

### 1.3 Käufliche Hochleistungs-Silizium-Solarzellen:

Die Zellkonzepte mit den höchsten Wirkungsgraden, die derzeit käuflich zu erwerben sind, sind die HIT-Zellen von ***SANYO Electric Co., Ltd.*** (SANYO) mit Modul-Wirkungsgraden von 16,2 % und 10 cm x 10 cm Labor-Solarzellen mit 21,8 % [Maruyama06], sowie die Rückkontakt-Solarzellen von

***SunPower Corporation^{®}*** (SUNPOWER) mit Modul-Wirkungsgraden von 17,7 % [SP-220 06] (die aktuellen Labor-Zellen-Wirkungsgrade müssten noch höher als bei SANYO liegen, aber sind nicht bekannt. Die Solarzellen aus der Massenproduktion für die 17,7 % Module besitzen 21.5 % Wirkungsgrad [SP-220 06]).

### 1.3.1 Erforderliche Maßnahmen zur Steigerung des Wirkungsgrads von HIT-Solarzellen:

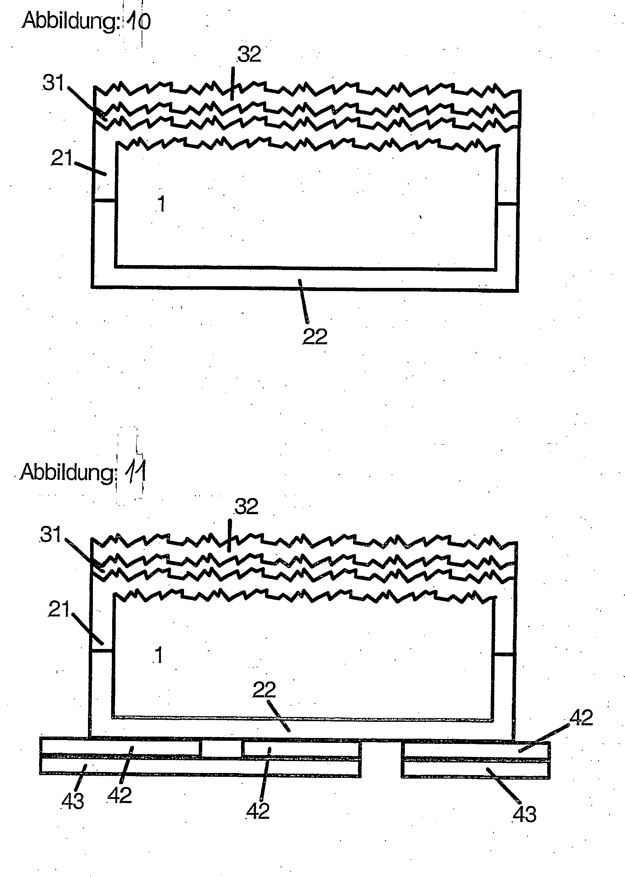

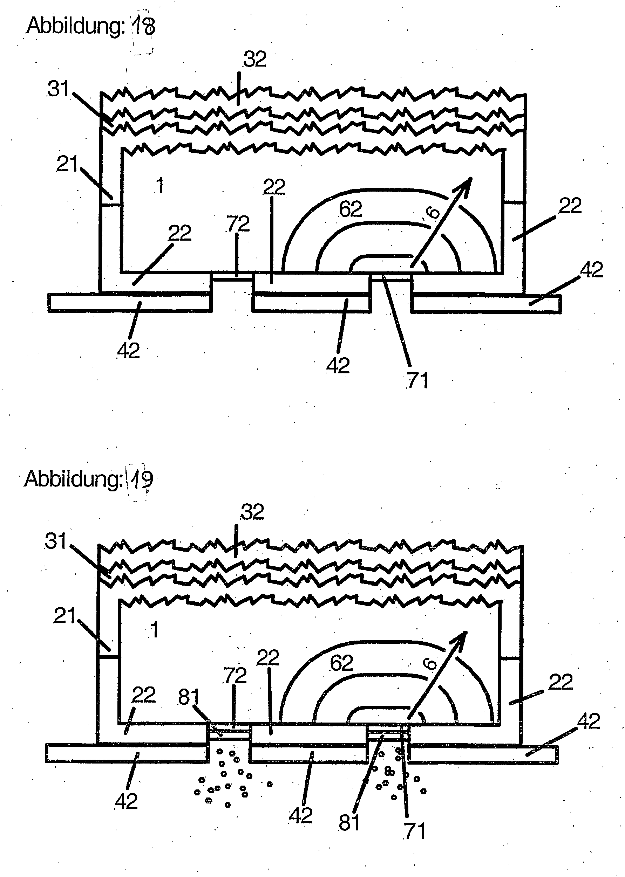

Die HIT-Solarzelle von SANYO hat die höchste Leerlaufspannung und einen sehr hohen Strom. Beides ist auf die sehr guten Hetero-Struktur-Kontakte zurückzuführen, die den Sättigungsstrom niedrig halten und ein sehr gutes Back-Surface-Field (BSF) erzeugen. Allerdings sind bei den Zellen, die im Modul verbaut werden, etwa 7 - 8 % der dem Sonnenlicht zugewandten Solarzellenoberfläche durch Metallkontakte (Fingerabstand 2 mm, Fingerbreite 85 µm [Taguchi05] und zwei Bus-Bars à ~2 mm Breite) verschattet¹. Der Flächenanteil der Metallisierung muss verringert werden. Zusätzlich treten Verluste durch Freie-Ladungsträger-Absorption des TCO im Wellenlängenbereich zwischen 300 nm - 450 nm auf (siehe Abb. 10 in [Sawad-a94], ähnlich auch Abb. 19 in [Maruyama06]).
¹Der hohe Strom der Rekord-HIT-Solarzelle kann nur in Verbindung mit einer geringeren Verschattung (andere Metallisierung als in der Massenproduktion, z.B. Aufdampfen und Elektroplattieren) erreicht worden sein.

### 1.3.2 Erforderliche Maßnahmen zur Steigerung des Wirkungsgrades von Rückkontakt-Solarzellen

Um noch höhere Wirkungsgrade bei den SUNPOWER-Zellen zu erreichen, die keine Metallisierung auf der Vorderseite besitzen, müssen andere Kontakt-Strukturen verwendet werden, um dort die Verluste zu minimieren. Dies wird in [Swansdn05) erläutert². Als Lösung wird auf die HIT-Kontakte verwiesen.
²R. Swanson ist Entwickler der Rückkontakt Zelle und Chef von SUNPOWER

Die Kombination von HIT-Kontakten mit einer Rückkontakt-Solarzelle ist für einen weiteren Wirkungsgradanstieg in Richtung des theoretischen Limits von 29 % für auf Silizium basierende Solarzelle erforderlich!

### 1.3.3 Weiterer Stand der Technik

In Die 10 2004 061604 A1 wird ein Plasmaätzverfahren beschrieben, bei der eine Schablone aus einer Metallfolie und einer Polymerfolie mit Öffnungen zur Erzeugung lokaler Plasmaentladungen auf der Solarzellenoberfläche verwendet wird. Diese Plasmaentladungen, dienen dazu, beispielsweise eine dielektrische Schicht auf der Solarzelle zu öffnen. Gemäß einer besonderen Ausführungsform wird die Schablone nach dem lokalen Öffnen einer Schicht auf der Solarzelle als Maske für eine lokale Metallisierung verwendet.

DE 198 19 200A1 beschreibt ein Verfahren, bei dem eine Ätzmaske auf die Solarzelle platziert und durch diese Ätzmaske hindurch eine diffundierte Emitterschicht durchgeätzt wird. Gemäß einer Ausführungsform kann hierfür Plasmaätzen eingesetzt werden. Anschließend erfolgt durch die Ätzmaske hindurch eine Metallisierung der Solarzelle.

US 2006/0130891 A1 betrifft eine rückkontaktierte Wafersolarzelle. Auf der Rückseite der Solarzelle sind gemäß einer Ausführungsform ein erster flächiger Kontaktbereich und eine Mehrzahl an zweiten punktförmigen Kontakten ausgebildet. Die Öffnungen zur Bildung der punktförmigen Kontakte werden mittels Laserbestrahlung oder mittels Ätzbehandtung erzeugt.

Die Publikation "Record Efficiencies above 21% for MIS-contacted Diffused Junction Silicon Solar Cells" von A. Metz et al. offenbart ein Verfahren zur Herstellung einer Hocheffizienzsolarzelle mit einem Metall-Isolator-Halbleiter-Kontakt. Die vorderseitigen Elektrodenfinger werden bei dem bekannten Verfahren durch eine Abscheidungsmaske hindurch aufgedampft. In dieser Publikation wird jedoch auch ein alternatives Abscheideverfahren offenbart, bei dem anstelle einer Abscheidungsmaske die Abschattung mittels Oberflächenausnehmungen in Zusammenhang mit einer schrägen Abscheidung erreicht wird.

### 2 Neue Idee:

Ungeachtet der vorliegenden Schutzrechte von SANYO besteht derzeit in der Solarzellen-Industrie und internationalen Solarzellen-Forschung ein sehr starkes, in den letzten Jahren stetig wachsendes Interesse an HIT-und Heterokontakt-Strukturen. Dieses ist einerseits durch ihre hervorragenden opto-elektronischen Eigenschaften für Solarzellen, andererseits durch den japanischen Wissensvorsprung begründet.

### 2.1 Was ist neu?

Die unten in einem Ausführungsbeispiel vorliegende neue Idee unterscheidet sich von den mir bekannten Verfahren, Patenten und Veröffentlichungen in folgenden Punkten:
- Der Silizium-Wafer wird zunächst komplett passiviert. und anschließend die zu kontaktierenden Stellen mittels Plasmaätzen geöffnet.
- Das Plasmaätzen erfolgt durch eine aufgespannte, dünne, elastische Folie mit lokalen linien- und /oder punktförmigen Öffnungen oder durch eine aufgelegte Maske mit lokalen linien- und /oder punktförmigen Öffnungen.
- Die gleiche Maske wird für Abscheideprozesse von lokalen Heterokontakten verwendet.
- Diese lokalen Heterokontakte können so gestaltet sein, dass sie für licht transparent sind.
- Diese lokalen Heterokontakte können so gestaltet sein, dass sie eine hohe interne Reflexion aufweisen.
- Die lokalen Heterokontakte verursachen geringere elektrische Verluste als herkömmliche, diffundierte Kontakte oder diffundierte lokale Kontakte und sind dadurch für höhere Solarzellenwirkungsgrade als bisher erreicht wurden geeignet.
- Bei Verwendung zweier übereinanderliegender Masken ist es möglich, Rückkontakt Solarzellen ohne Photolithografie, Diffusion und Nasschemie zu erstellen.
- Im Falle der Rückkontaktsolarzellen befinden sich Emitter- und Basiskontakt beide auf der SolarzellenRückseite. In allen mir bekannten SANYO Patenten werden immer Solarzellen beschrieben, bei denen sich der eine Kontakt auf der Forder- und der andere Kontakt auf der Rückseite befindet!
- Es entfällt ein genaues Positionieren der einzelnen Ätz- und Abscheideprozesse (Selfalignement)
- Ein Verschleppen von Plasma-Rückständen vorheriger Plasmaprozesse wird minimiert.
- Um hohe Diffusionslängen zu erreichen, kann die Probe, als zusätzlicher Prozessschritt, lokal, durch die selbe Maske einem Wasserstoffplasma ausgesetzt und so ein Dotiergradient mit Hilfe von Thermischen Donatoren erzeugt. So können bei Rückkontak-Solarzellen größere Distanzen zwischen Emitter- und Basiskontakt bei Verwendung von günstigem Czochalski-Material verwendet werden. Für herkömmliche und Wrap-Through Solarzellen erhöht sich die Einfangwahrscheinlichkeit.

### 2.2 Neues Verfahren

### 2.2.1 Plasmaätzen und Abscheiden durch Schattenmasken :

Bei dem neuen Verfahren soll eine ganzflächig aufgebrachte passivierende Schicht durch Plasmaätzen an den späteren Kontaktstellen geöffnet werden. Um die Passivierungsschicht nur lokal zu ätzen, wird hierzu die passivierte Halbleiterprobe (z.B. durch Oxidation, Abscheidung von a-Si:H, SiN:H, a-SiC:H, SiC,... ) mit einer Schattenmaske abgedeckt und dann geätzt. Die Maske dient anschließend als Abscheidemaske für einen Heterokontakt. Bei Verwendung von zwei übereinander liegenden Masken, bei der die obere nur jede zweite Öffnung aufweist, können so auch Rückkontaktzellen [Mulligan04] erstellt werden. Der Ätzvorgang kann z.B. in einer RIE-Pinlage (Reactive Ion Etching) mit Ätzgasen wie z.B. SF₆, CHF₃, CH₄, O₂, NF₃ etc. erfolgen. Jüngst sind auch gute Ergebnisse mit Atmospheric Pressure CVD-Anlagen (AP-CVD) erreicht worden, bei denen die komplette Vakuum-Technologie entfällt und so Investitions- und Wartungskosten sowie Pumpzeiten eingespart werden können.

### 2.2.2 Erzeugung von lokalen Driftfeldern mittels Thermischer Donatoren durch Sahattenmasken:

Außerdem kann die Maske dazu verwendet werden, in Solarzellen lokal Thermische Donatoren (TD) aus intrinsischem Sauerstoff zu erzeugen. Thermische Donatoren können in Sauerstoff reichem Silizium mit Hilfe von Wasserstoff erzeugt werden. Setzt man eine Sauerstoff reiche Siliziumprobe, z.B. Standard-Czochalsky-Silizium (Sauerstoffanteil von ca. 10¹⁸ cm⁻³), einem Wasserstoffplasma aus, so diffundiert der Wasserstoff in das Silizium. Es entsteht ein Wasserstoff-Konzentrationsgradient. Entlang dieses Gradienten formieren sich mehrere Sauerstoffatome zu Donatoren um (durch Tempern bei z.B. 450 °C; daher der Name ,Thermische Donatoren'). Die Dotierung geschieht proportional zu der Wasserstoffkonzentration. Es lässt sich so, abhängig von der Wasserstoffkonzentration, ein Dotiergradient erzeugen [Job98]. Die maximale Dichte an TD beträgt, abhängig von der Sauerstoffkonzentration im Silizium, etwa 3 × 10¹⁶ cm⁻³. Dies genügt zur Umdotierung von p-Typ Material. Mit Hilfe dieses Verfahrens lässt sich z.B. ein pn-Übergang erzeugen (Abb. 2a in [Huang04]). Bei höheren Temperaturen wie z.B. 550 °C lassen sich innerhalb von 20 min 300 µm µm tiefe, Gradienten erzeugen.

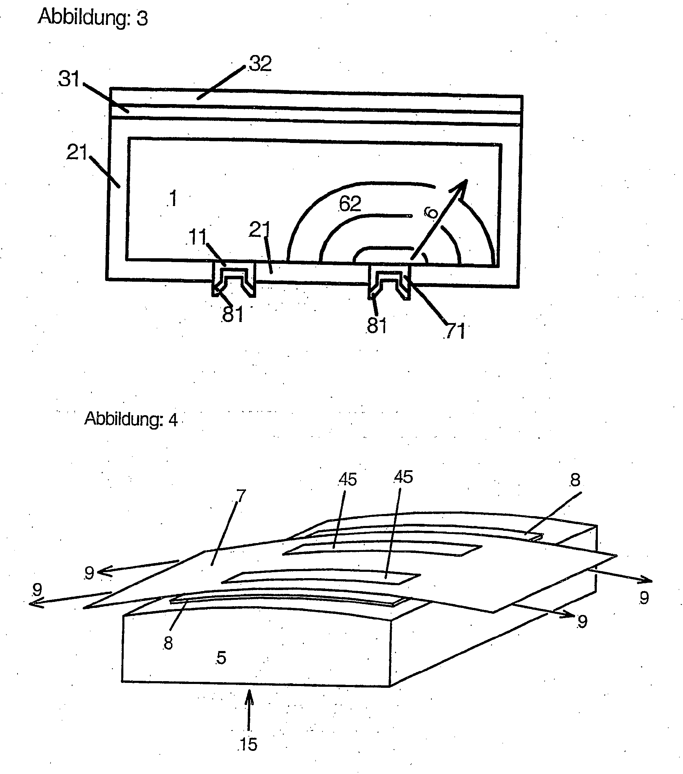

Die Erzeugung von Dotiergradienten (auch ohne pn-Übergang) hat eine wesentlich verbesserte Einfangswahrscheinlichkeit für die Minoritäts-Ladungsträger zufolge (Abb. 3 in Scherff06), da diese zu den Kontakten hin beschleunigt werden, sobald sie sich in dem Driftfeld (DF) befinden. In eigenen Versuchen ist eine Verdoppelung der effektiven Diffusionslänge (Abb. 4 in Scherff06) bei Anwendung der TD zu beobachten, obwohl aufgrund der Wasserstoff-Plasmabehandlung (der verwendete Prozess war nicht für Solarzellen optimiert worden) eine Schädigung der Rückseite aufgetreten ist.

Dieses Verfahren wird schon in [Ulyashin01] vorgeschlagen, allerdings nicht für lokale Driftfelder.

Erfolgt die Wasserstoffplasmabehandlung durch die oben beschriebene Maske, könnten so lokale Dötiergradienten (Driftfelder), ähnlich zu lokalen BSFs (Back Surface Field), wie in z.B. [Green98] erzeugt werden. Allerdings können diese BSFs in gleicher Zeit und bei niedrigeren Temperaturen wesentlich tiefer ins Substrat hineinragen. Dies hat dann eine deutlich verbesserte Einfangwahrscheinlichkeit für die Minoritäts-Ladungsträger, insbesondere für Substrate deren Diffusionslänge groß gegenüber der Waferdicke ist, zufolge, da diese zu den Kontakten hin beschleunigt werden, sobald sie sich in dem tiefen Driftfeld befinden. Bei Rückkontakt-Solarzellen können die Driftfelder lateral von den Emitter- zu den Basiskontakten wirken. Der Einfluss von Driftfeldern auf den Solarzellenwirkungsgrad wird in [Cuevas97] untersucht. Auch wenn die untersuchten Zellstrukturen verschieden von den hier beschriebenen Strukturen sind, ist festzuhalten, dass die Diffusionslänge in Richtung des Driftfeldes um Faktor 3 bis 10 erhöht wird, wenn ein Dotiergradient von einer bzw. zwei Größenordnungen vorliegt. Um den gleichen Effekt durch Verwendung eines besseren Siliziummaterials zu erreichen, müsste Silizium mit einer verzehnfachen bzw. verhundertfachen Minorität-Träger-Lebensdauer verwendet werden.

Da durch Thermischen Donatoren maximal nur 3.10¹⁶ cm⁻³ Donatoren erzeugt werden können und für einen Dotiergradienten von ein bis zwei Größenordnungen die Substratdotierung folglich bei 3·10¹⁵ cm³ bzw. 3·10¹⁴ liegt, wird ein zusätzliches BSF erforderlich, um hinreichend hohes Built-In-Potential und dementsprechend hohe Leerlaufspannungen zu erhalten. In den Beispielen bilden die hochdotierte amorphen Siliziumschichten des Rückkontaktes das BSF.

### 2.3 Verfahrens-typische Anforderungen :

Wie oben schon teilweise beschrieben, sind folgende Sachverhalte noch zu bearbeiten:
- Die Oberflächenpassivierungsschicht, die maßgeblich für hohe Solarzellen-Wirkungsgrade ist, darf nicht beschädigt werden, sonst folgen Leistungseinbußen [Breitenstein06]. Je nach Dicke und Härte der Passivierungsschicht und Material der Schattenmasken, die direkt auf der Passivierungsschicht aufliegen, ergibt sich hier noch ein Entwicklungsbedarf.
   Die Passivierung ist in der Regel aus einem sehr harten Material (SiO₂, SiN:H, a-Si:H, a-SiCₓ, SiCₓ, oder ähnlich). Um sie dennoch zu schonen, muss die Schattenmasken sanft aufgelegt werden oder kann mit einer weichen, z.B. einer Polymerschicht beschichtet sein. Bei Verwendung von dünnen Folien, die auch mit weichen Beschichtungen versehen sein können oder völlig aus einem Polymer bestehen, wird auf diese weise kein Problem auftreten. Auch bei Verwendung von Metallfolien besteht bei harten Passivierungsschichten keine Gefahr, wenn die Folien dünn (flexibel) sind und keinen Grat durch den Strukturierungsprozess (Öffnen der Masken mit Lasern, Wasserstrahl, ...) aufweisen. Evtl. vorhandene Grate können durch Ätzen oder Schleifen entfernt werden).
   Da die Öffnung der Kontakte auf der dem Licht abgewandten Seite erfolgt, kann die Passivierung dort auch dicker ausfallen. Auf die Passivierung kann auch eine harte Schutzschicht aufgetragen werden, um diese mechanisch widerstandsfähiger zu machen.
- Die aufgespannten Folien bzw. Masken müssen ganzflächig überall so dicht auf den Proben aufliegen, dass es nicht zu Unterätzungen der Masken kommt. Dies könnte zu lokalen Kurzschlüssen führen, wenn Emitter- und Basiskontakt sich berühren(Abb. 1, Lokaler Kurzschluss (3) aufgrund nicht press anliegender Schattenmaske (42). Kontakt zwischen Emitter (11) und BSF (71) unterhalb der Maske).
   An den Stellen, an denen die Maske nicht press aufliegt, fallen die Ätz- und Abscheideraten von der Maskenkante her rapide ab, sodass die Kontakte evtl. etwas breiter werden und/oder die Passivierungsschicht etwas dünner wird. Um einen Kurzschluss zu erzeugen muss die Maske sehr schlecht aufliegen.
   Durch Wahl entsprechender Prozessparameter ist der Ätzprozessso zu führen, dass die Ätzrichtung möglichst senkrecht zur Waferoberfläche gerichtet ist. In [Jansen95] wird ein solches Verfahren für einen Siliziumprozess beschrieben (dieser ist, z.B. zum Wegätzen einer Passivierungschicht aus a-Si:H geeignet).
   Sollte es doch zu einem Kurzschluss zwischen Emitter und Basiskontakt gekommen sein, wird die Schichtdicke, die den Kurzschuss bildet sehr gering sein. Nach erfolgter TCO und/oder Metallabscheidung kann durch einen kurzen, ganzflächigen Ätzprozess dieser Kurzschluss beseitigt werden. Aufgrund der Ätzselektivität der einzelnen Plasmaätzprozesse kann außerdem ungewolltes Ätzen der anderen Schichten vermieden werden (das TCO bzw. Metall maskiert die Kontakte. Beseitigung des Kurzschlusses (3) zwischen Emitter (11) und BSF (71) durch einen kurzen und selektiven Ätzprozess (54). Das TCO (81) maskiert die Kontakte. Abb. 3, Emitter (11) und BSF (71) werden unter dem TCO (81) nicht beseitigt).
- Die Proben werden zusammen mit den Masken in verschiedene Prozessanlagen transportiert. Hierbei dürfen die Masken nicht verrutschen.
   Dies stellt eine mechanisch lösbare Anforderung bei Verwendung dicker Schattenmasken dar. Im Falle von aufgespannten Masken ist kein Verrutschen möglich (Abb. 4, Der passivierte Wafer (8) wird auf den konkav gewölbten Carrier (5) gelegt und beide durch die Kraft (15) gegen die, durch Zugkräfte (9) gespannte Folie (7) gedrückt. Hierdurch passt sich der Wafer und die Folie der Wölbung des Carriers an. Die Folie liegt press auf und kann nicht mehr verrutschen. Durch die lokalen Öffnungen (45) der Folie können nun die Ätz-und Abscheideprozesse erfolgen).
- Die Prozesse müssen möglichst rückstandsfreie Oberflächen hinterlassen, die nur geringe Oberflächenschädigung aufweisen um die Solarzelleneigenschaften nicht negativ zu beeinflussen. In [Stang101, Stangl03] wird der Einfluss von Defekten an dem a-Si:H/c-Si pn-Übergang beschrieben.
   Bekannte Plasmaätzprozesse hinterlassen häufig Ätzrückstände [Zhang00], die beseitigt werden müssen. Eine Möglichkeit wird in [Lim98] beschrieben.
   Ätzrückstände können durch sequentielles Ätzen (zwei aufeinander folgende Prozesse bei denen der zweite nur die Rückstände des ersten entfernt) beseitigt werden.
   Auch mit sehr aggressiven Plasmaätzprozessen und ohne Beseitigung dieser Rückstände sind brauchbare Solarzellen erstellbar [Salsuro01, Tucci01].
   In den SANYO-Patent [SANYO03a] wird beschrieben, wie Verunreinigungen auf der Siliziumoberfläche beseitigt und/oder kompensiert werden.
   In [Glunz06] wird in-situ zunächst ein Wafer durch einen Plasmaprozess gereinigt und anschließend mit SiCₓ die Oberfläche passiviert. Mit diesem Verfahren wurden hervorragende Ergebnisse erreicht.

### 2.4 Vorteile :

### 2.4.1 Vorteile gegenüber Rückseitenkontakt - Solarzelle:

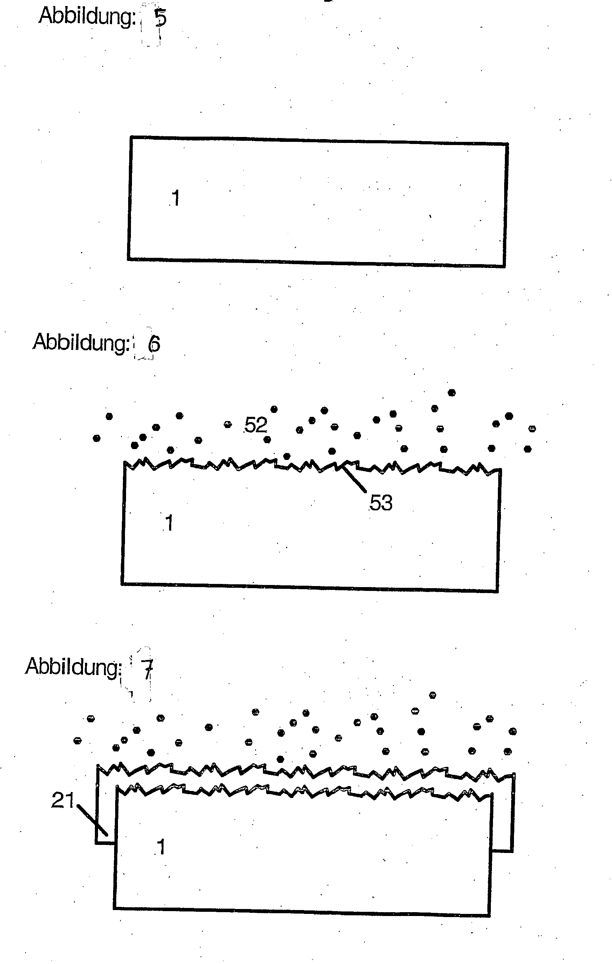

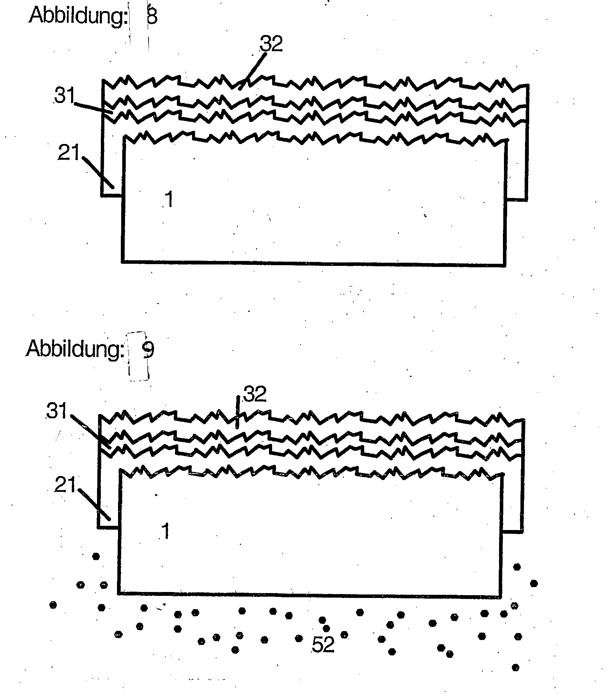

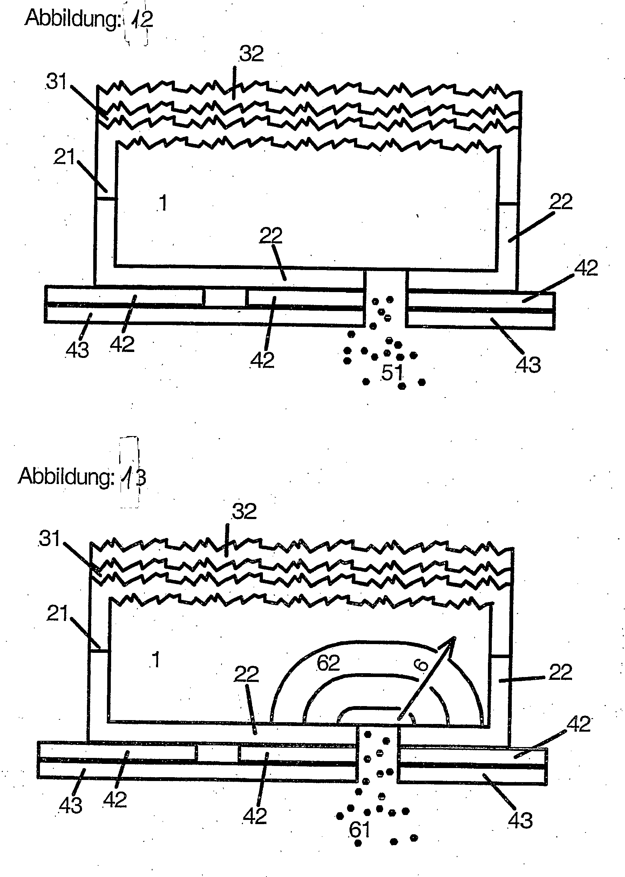

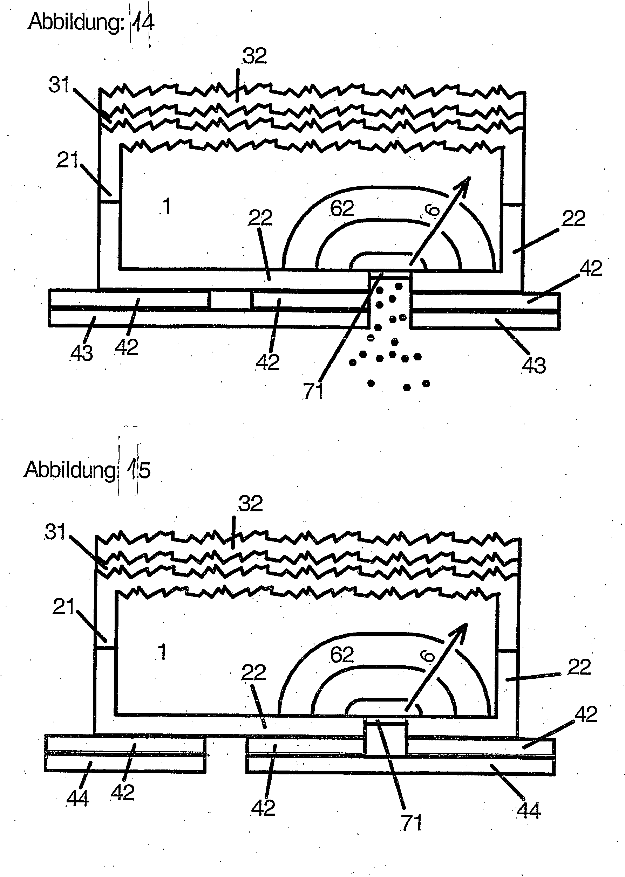

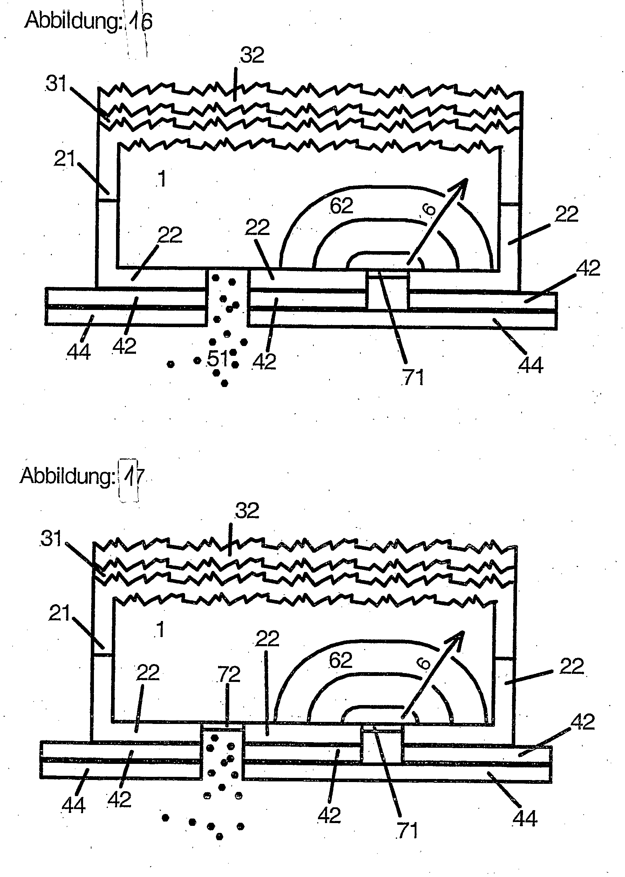

- **Der Emitter- und Basiskontakt wird, anstatt durch Diffusion von Dotierstoffen, durch Abscheidung von Hetero-Struktur-Kontakten durch Schattenmasken gebildet:**
   ∘ Anderer Prozess als bei SUNPOWER und SANYO
   ∘ Höheres Spannungsniveau (Rekordzelle hat 719 mV Leerlaufspannungen; höchster Wert bis 730 mV [Maruyama06]) aufgrund von geringerem Sättigungsstrom an den Kontakten [Swanson05] (Mit HIT-Kontakten wird ein Sättigungsstrom von J₀ = 18 fA/cm² erreicht, Diffundierte erreichen nur J₀ = 1000 fA).
   ∘ HIT-Solarzellen weisen mit -0,25 %/°C (Laborzelle) bzw. -0,28 %/°C (Massenproduktion) einen geringeren leistungsbezogenen Temperaturkoeffizienten als herkömmliche Solarzellen (~ - 0,45 %/°C) oder Rückkontakt-Solarzellen (~ - 0,38 %/°C) auf [Taguchi05].
- **Kontaktflächen können größer als bei Sunpower A300 ausfallen da HIT Kontakte einen um Faktor 40 geringeren Sättigungsstrom als Halbleiterkontakte/Metall** aufweisen [Swanson05].
   ∘ Größere Strukturen erlauben einfacheres Alignement mit alternativen Metallisierungen (Niedertemperatur-Siebdruck Metallisierung auf TCO [Windgassen05] oder geklebte Zellverbinder auf TCO [Scherff06] anstatt gelöteter Zellverbinder)
   ∘ Eine größere Kontaktflächen bedeutet geringere Probleme mit dem Solarzellen-Serienwiderstand.
- **Es sind keine Hochtemperaturschritte notwendig, die immer in Verbindung mit diffundierenden Verunreinigungen stehen.**
   ∘ Die Diffusionslänge wird nicht negativ beeinträchtigt
   ∘ Keine Phosphordiffusion (viele Arbeitsschritte)
   ∘ Keine Bordiffusion (viele Arbeitsschritte, oberste Schicht der Bor-Dotierung (Boron-Rich-Layer) müsste evtl. wieder beseitigt werden)
   ∘ Für den Fall, dass die Oberfläche mit SiO₂ passiviert werden soll, kann dies aber auch durch eine nasse Oxidation bei nur ∼850 °C geschehen.
- **Sehr gute interne Reflexion der Rückseite**
   ∘ Bei Verwendung von a-Si:H/TCO/Metall-Kontakten anstelle von a-Si:H/Metall-Kontakten wird eine sehr hohe interne Reflexion aufgrund des niedrigen Brechungsindexes des TCO (ITO, ZnO n ~ 1,8) erreicht³.
      ³ SUNPOWER hat eigenes Patent auf eine Kontaktstruktur mit gut reflektierendem Metall [MulliganPAT06]
   ∘ Je nach Schichtaufbau wird auch für die Flächen zwischen den Kontakten eine sehr hohe interne Reflexion erreicht (z.B. mit SiO₂ oder einem anderen Material, das einen niedrigen Brechungsindex aufweist oder mit Mehrschichtsystemen mit einer ersten Schicht mit niedrigem Brechungsindex)
- **Sehr einfacher Prozess**
   ∘ Keine Photolithographie
      ▪ Schattenmasken werden verwendet
      ▪ Billiger
   ∘ Wenige Prozessanlagen sind nötig. Im Idealfall können alle Plasmaprozesse in einer Kammer erfolgen⁴, da durch die Plasma-Ätzprozesse und Wechsel der Masken eine Verschleppung von Stoffen aus dem vorherigen Prozess minimiert wird.
      ⁴ Dies ist nur eine Vermutung. a) In unserer Drei-Kammer-Anlage sind noch keine Effekte durch Verschleppung aufgefallen, vermutlich da unsere Prozesse mit geringer Wasserstoffverdünnung gefahren werden und so die Deposition maßgeblich durch eine Abscheidung der a-Si:H-Schichten und weniger durch ein Ätzen durch einen hohen Wasserstoffanteiles charakterisiert ist. b) Zwischen den Abscheidungen gegen-dotierter Schichten erfolgt in den Beispielen ein Ätzprozess zum Öffnen der Passivierungsschicht, der die Reste von zuvor abgeschiedenen Layern anderer Dotierung beseitigt, c) Bei Verwendung zweier tlbereinander liegender Masken (Rückkontakt-Solarzelle) werden die Quellen für eine mögliche Redeposition abgedeckt.
- **Zeitersparnis**
   ∘ Höherer Durchsatz
   ∘ Bessere Prozesskontrolle durch kürzere Prozesszeit
- **Geringerer Waferbruch dadurch, dass**
   ∘ monokristalline Wafer verwendet werden.
   ∘ die Wafer nicht frei-schwingend transportiert werden.
   ∘ die Wafer nicht häufig in und aus Carriern sortiert werden.
   ∘ die Wafer unter der Folie fixiert⁵ sind (Abb. 13).
      ⁵ Bei Verwendung der Schattenfolien werden die Wafer auf die Mantelfläche eines zylinderförmigen Carriers gelegt und die Schattenfolie darüber gespannt. Die erforderliche Durchbiegung ist sehr gering (Zylinderradius ~3 m). Dies ist selbst für 350 µm dicke Wafer kein Problem. Da sich der Wafer nur in dem ihm vorgegebenen Radius biegen kann, können keine hohen lokalen mechanischen Spannungen in ihm auftreten. Die Spannungen sind homogen über die Fläche verteilt. Der Wafer ist praktisch in eine Art Korsett gespannt. Ohne dieses Korsett führen einwirkende Kräfte zu parabelförmigen Verformungen und so zu extremen, lokalen, mechanischen Spannungen, die dann zum Bruch führen.
- **Weniger Prozesssehritte durch Self-Alignment (nur eine Maske mit einer Übermaske), dadurch gibt es:**
   ∘ geringere Investition und laufende Kosten,
   ∘ eeniger mögliche Fehlerquellen,
- **Tiefe Dotiergradienten können in sehr kurzen Zeiten erzeugt werden.**
   ∘ z.B. 300 µm tief in 20 min bei 550 °.
   ∘ Dadurch werden tiefe Driftfelder erzeugt und ein gerichteter Fluss der Ladungsträger zu den Kontakten wird stark forciert. Die Diffusionslänge steigt z.B. um Faktor 3 oder 10 bei einem Dotierkonzentrationsgradienten von ein bzw. zwei Größenordnungen [Weber97]. Hierzu müsste sich die Ladungsträgerlebensdauer ca. um ein bzw. zwei Größenordnungen erhöhen!
   ∘ Cz-Material niederer Qualität (gerade solches mit viel Sauerstoff) kann verwendet werden, da sich die Diffusionslänge durch TD-Driftfeld stark erhöht. Es ist kein magnetisch gezogenes mCz- oder teures Float-Zone-Silizium notwendig.
   ∘ Kontakte können weit auseinander liegen (einfaches Alignement)
- **Dickere Wafer können verwendet werden.**
   ∘ Dadurch kann der Reflexionsgrad der Rückseite geringer ausfallen und IR besser gesammelt werden. (Bei dünnen Wafern gute Reflexion mit TCO auf a-Si:H Schichten, siehe oben)
   ∘ Geringerer Waferbruch
- **Dünne Wafer können verwendet werden.**
   ∘ Aufgrund der hervorragenden Oberflächenrekombination
   ∘ Aufgrund der sehr guten Refexionseigenschaften der Rückseite
- **Auf die Metallisierung kann verzichtet werden.**
   ∘ Metallfolie als Zellverbinder wird direkt auf die TCO-Schichten mit leitfähigen Polymerklebern geklebt. Die Metallfolie hat eine kammartige Struktur, die deckungsgleich zu den ,Interdigitated Contacts' der Rückkontakt Solarzelle ist⁶. Siehe auchAbb. 32 und 33.
      ⁶ Die Kontaktfolie kann auch durch eine Prägung in Wellen- Schlangenlinien oder Waffelform ausgeführt sein. Dies dient zur Verringerung von Zugspannungen, hervorgerufen durch unterschiedliche Wärme-Ausdehnungskoeffizienten des Kontaktstreifens und des Wafers.
   ∘ Keine Verwendung von Silber, Mehrschichtsystemen [MulliganPAT06], oder Siberpasten. Z.B. Kupfer- oder Alufolie möglich..
   Vorteile gegenüber konventioneller HIT Technologie:
- **Die dem Licht zugewandte Seite kann völlig neu gestaltet werden. Die Verwendung einer beliebigen Antireflexschicht (ARC) ist nun möglich. Die ARC muss nicht elektrisch leitfähig sein. Dadurch ist man unabhängig von:**
   ∘ der TCO-Querleitfähigkeit. Bei zu geringer Leitfähigkeit muss die TCO-Schichtdicke über 80 nm erhöht werden (größere Reflexion) oder der Gridfingerabstand verringert werden (höhere Abschattung). Beides führt zu Leistungseinbußen.
   ∘ den optischen Eigenschaften (keine Free Carrier Absorption im TCO), dadurch geringere Absorptionsverluste im Kurzwelligen (siehe Abb. 9 in [Maruyama06]).
   ∘ den Kontakteigenschaften zum a-Si:H/TCO und TCO/Metallkontakt. Bei zu dünnen a-Si:H Schichten (z.B kleiner 5 nm) kann es zu deren Verarmung durch ein zu großes a-Si:H/TCO Built-In-Potential kommen, was zur Verringerung der Leerlaufspannung und des Füllfaktors führt. Dies kann nur teilweise durch Abscheidung dickerer a-Si:H Schichten kompensiert werden (Abb. 5a und 5b in [Stang103]. Zusätzlich verursachen steigende Schichtdicken auf der Forderseite Absorptionsverluste.
   ∘ dem Brechungsindex des TCO. Bei hoch leitfähigen und gleichzeitig im optischen Spektralbereich hoch transparenten TCOs wie ZnO, ITO ist dieser kaum variierbar (n ~ 1,9). Durch Verwendung von dielektrischen ARCs wird ein Doppelschicht ARC mit geringerer Reflexion und Absorption möglich. Dadurch kann auch auf eine Texturierung der Vorderseite verzichtet werden, um so die Grenzflächen-Defektdichte der Vorderseite zu minimieren.
   ∘ Darüber hinaus werden Mehrschicht-ARCs mit besonderer Ausrichtung auf sehr gute optische Eigenschaften und eine sehr gute Oberflächenpassivierung möglich (z.B. a-Si:H/a-SiN:H, a-Si:H/SiOₓ, SiO₂/a-SiN:H, a-SiCₓ/SiC, a-SiCₓ/a-SiN:H, ...).
- **Die Kontakte können mit Siebdruck erstellt werden.**
   ∘ Emitter- und Basiskontakt können in einem Druck erstellt werden.
   ∘ Es ist weniger Paste nötig als bei einem kompletten Rückkontakt (wie bei herkömmlichen Solarzellen und auch HIT-Solarzellen üblich).
   ∘ Es ist nur eine geringe Pastenhöhe notwendig, da die Finger auch breiter ausfallen können (Keine speziellen Pasten, Doppeldruck oder Hot-Melt erforderlich)
      ▪ Das Aspektverhältnis spielt eine untergeordnete Rolle (SANYO macht -0,5. Käufliche Niedertemperpasten erreichen nur ~0**,**1).
   ∘ Mit herkömmlichem Niedertemperatur-Siebdruck direkt auf ITO werden niedrige Kontaktwiderstände von R_{C} = 2 - 3 m□/cm² [Windgassen05] erreicht. Mit neuen Pasten, die an der RWTH-Aachen entwickelt ∘
   ∘ wurden, werden R_{c} < 0,1 m□/cm² erreicht [Windgassen, mündlich August 2006].
- **Bus und Gridfinger entfallen**
   ∘ Keine Abschattung durch Bus und Gridfinger (Abschattung bei SANYO -7,6 % % → 2,8 mA; ~50 Finger (2mm spacing) x 85µm x 10 cm ~= 4,25cm² Abschattung durchs Grid + 10cm x 2 x ~1,7mm ~= 3,4cm² [Taguchi05].
      Außerdem ergeben sich folgende Vorteile:
      ▪ Es ist keine Entwicklung von Siebdruckpasten mit hohem Aspekt-Verhältniss, geringem Kontaktwiderstand und hoher Leitfähigkeit nötig, die gleichzeitig langzeitstabil sind und bei niedrigen Curing-Temperaturen aushärten.
      ▪ Die Curing-Bedingungen der Siebdruckpasten wie auch der Sputterprozess des TCO (UV-Strahlung und Plasmaschaden) können die pn-Junction beeinträchtigen.
   ∘ Bei Verwendung von Siebdruckpasten auf der Rückseite können solche mit schlechterem Aspektverhältnis, Kontaktwiderstand und spezifischer Leitfähigkeit verwendet werden (mit geringe Kosten, da der Entwicklungsschwerpunkt anders gesetzt werden kann, z.B. Langzeitstabilität, Handhabung etc.).
   ∘ große Wafer (z.B. 20 cm × 20 cm) können ohne Serienwiderstands-Verluste (Bus, Grid) verwendet werden.

### 2.4.2 Sonstiges

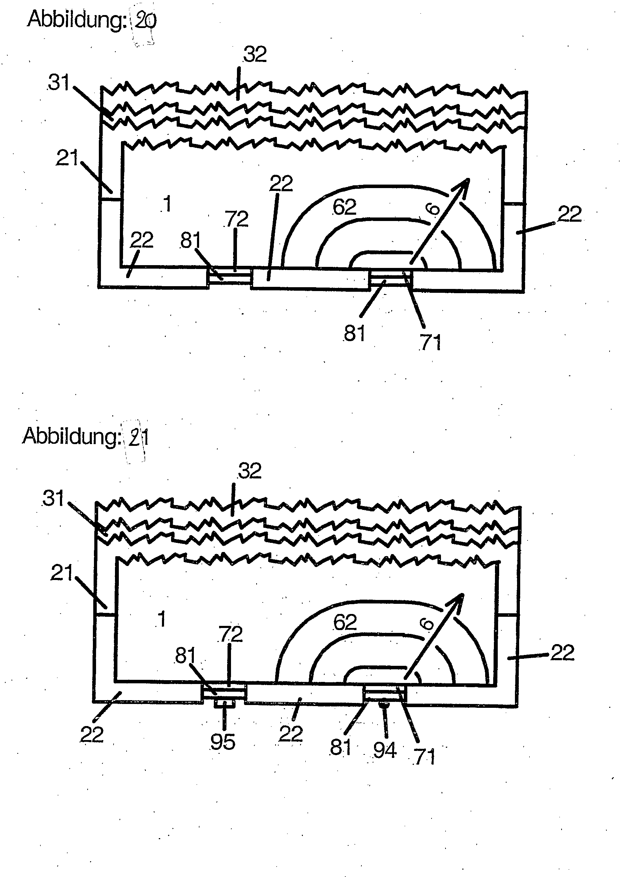

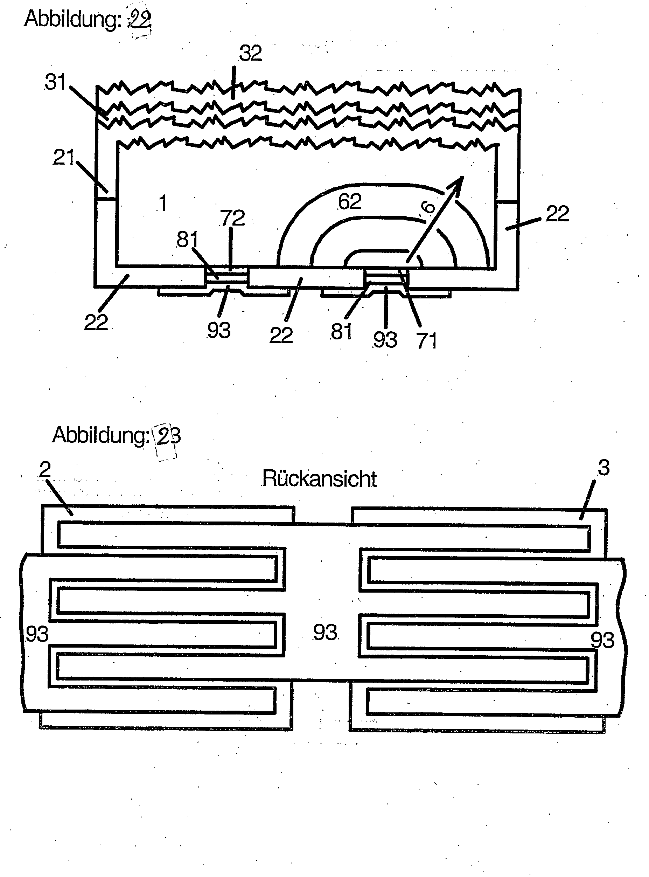

- **Die komplette Waferoberfläche ist passiviert (auch die Kontakte). Keine Passivierungsenken als Ursprung für große J₀**
- **Sehr gute Passivierung der Oberflächen und Kanten durch Heterostrukturen und Feldeffekt möglich**
   ∘ Vorder- und Rückseite können auch unterschiedlich passiviert werden, z.B. vorne mit Feldeffekt (wie bei SUNPOWER), hinten ohne Feldeffekt (keine Probleme mit Kontakten, die Inversionsschichten durchdringen.)
- **Kein Shunting an Inversionsschichten** [Dauwe02]
   ∘ durch Verwendung intrinsischer a-Si:H, a-SiCₓ, SiCₓ, ... Schichten
   ∘ für den Fall, dass Schichten Verwendung finden sollen, die Inversionsschichten verursachen, wird der Shunting-Effekt geringer sein wenn ein Driftfeld (Kap. 2.2.2) verwendet wird, da die Kontaktregion aufgrund des Driftfeldes an Minoritätsladungsträgern verarmt ist.
- **Geklebte Zellverbinder sind möglich**
   ∘ Bei Verwendung von Rückkontakt-Solarzellen ist eine einfachere Verbindungstechnik möglich.
   ∘ Wird auf die HIT-Kontakte TCO abgeschieden, können die Zellverbinder auch direkt aufgeklebt werden (es ist dann keine Metallisierung mehr notwendig).
   ∘ Die Klebestellen befinden sich auf der Solarzellen Rückseite und sind so vor UV-Strahlung geschützt, was sie langzeitstabiler macht.
   ∘ Die Klebefläche der Zellverbinder kann groß ausfallen, da sie sich auf der Solarzellenrückseite befinden.
- **Polymerkleber gibt guten Kontakt TCO**
   ∘ Dadurch kann auf eine Metallisierung verzichtet werden.
   ∘ Die Zellverbinder (z.B. Kupferfolie) werden mit leitfähigen Klebern direkt auf die auf die TCO-Schicht geklebt [Scherff06b].
- **Keine Perimeterverluste**
   ∘ Vorteil bei niedriger Einstrahlung [Glunz02]
   ∘ Waferkanten sind rundum Passiviert (nicht nur bei oxidierten Wafern).
- **Bei Verwendung von n-Typ Substrat ist der Hetero-pn-Übergang weniger empfindlich gegen Interfacedefekte [Stang101]**
- **Keine Light Induced Degradation**
   ∘ wenn FZ- oder n-Typ Cz-Siliziumwafer verwendet werden
   ∘ Keine Degradation der Kontakte wie bei Cz-Wafern mit diffundiertem Bor-Emitter oder Bor-BSF
- **Hohe Phong Exponenten an der Rückseite sind möglich (more specular reflection) z.B. mit a-SiC:HJSiN:H Rückseite [Hermle05]**
- **Werden Emitter und Basis auf glatte (polierte) Oberfläche abgeschieden sind geringere Grenzflächendefektdichte zu erreichen.**
- **Bifacial Solarzellen sind bei Verwendung von a-Si : H/TCO/Metall (schmale Kontakte) möglich** (siehe Abb. 21, Die elektrisch leitfähige TCO-Schicht (81). sammelt den Strom der dünnen Emitter- (72) und BSF-(71) Kontakte und leitet ihn zu den Metallfingern (94 bzw. 95). Die Rückseite ist weitgehend transparent).
- **Teurer RCA Prozess angeblich nicht erforderlich laut** [Maruyama06] **und Uni Stuttgart** [Jensen02]
- **Viel Wasserstoff befindet sich im Wafer (nach H₂**-**Plasma zur Erzeugung Thermischer Donatoren).**
   ∘ Dieser kann während der Erzeugung des Driftfields Defekte passivieren. (atomarer Wasserstoff diffundiert sehr schnell; sehr viel schneller als die TDs erzeugt werden). Er kann auch bis zur Vorderseite diffundieren und dort die Grenzfläche passivieren.
- **Als Emitter und BSF Heterokontakte genügt es, nur nc-Si Kontakte ohne TCO abzuscheiden.**
   ∘ Dies ist einfach zu prozessieren.
   ∘ Erzielt gute Leitfähigkeit [Farrokh-Baroughi06]
- **Keine Waferdurchbiegen**
   ∘ bei Verwendung geklebter Kontakte in Verbindung mit Meander-, Waffel- oder Wellenförmiger Zellverbinder

### Zusätzliche Ausführungen zu dem Solarzellen-Herstellungsverfahren

Das Aufspannen einer Folie mit lokalen Öffnungen hat im Gegensatz zu Verfahren die Photolithographie verwenden den Vorteil, dass:
- für die Ätzprozess, wie für den optionalen Wasserstoffprozess und die Abscheideprozesse die selbe Folie verwendet wird und diese für alle Prozesse auf der Probe verbleiben kann,
- die Maskierung nicht für jeden Prozess neu positioniert werden muss,
- die Probe beim Transport fest eingespannt ist und so nicht durch Schwingungen beim Transport brechen kann (es sind viele Prozeßschritte notwendig um eine Solarzelle zu erstellen. Hierfür wird die Solarzelle normalerweise oft auf Transportbändern bewegt oder mit Robotern umsortiert),

Das Aufspannen der Folie hat im Gegegnsatz zu aufgelegen Masken den Vorteil, dass die Folie press auf der Oberfläche aufliegt und so ein Unterätzen oder eine Abscheidung unter die Folie vermieden wird.

Die Folie soll dünn sein, damit die Öffnungen nicht tief sind, wie bei einer dicken Maske, da das die Abscheiderate herabsetzt und die die Abscheidebedingungen beeinflusst.

Das Aufspannen erfolgt dadurch, dass die passivierte Halbleiterprobe auf eine gewölbte Fläche (z.B. einem Abschnitt einer Zylindermantelfläche mit 3 m Durchmesser) gelegt wird. Dies rist selbst für 350 [mu] m dicke Wafer kein Problem. Da sich der Wafer nur in dem ihm vorgegebenen Radius biegen kann, können keine hohen lokalen mechanischen Spannungen in ihm auftreten. Die Spannungen sind homogen über die Fläche verteilt. Der Wafer ist praktisch in eine Art Korsett gespannt. Ohne dieses Korsett führen einwirkende Kräfte zu parabelförmigen Verformungen und so zu extremen, lokalen, mechanischen Spannungen, die dann zum Bruch führen. Die parallel zu Auflagelinie befindlichen Waferkanten stehen etwas in der Luft. Dann wird die darüber befindliche durch eine Kraft gespannte Schattenfolie mit den lokalen Öffnungen von oben parallel auf die Probe gedrückt, sodass sich diese auf die Zylindermantelfläche biegt. Dadurch ist gewährleisten, dass die Folie überall press auf der Probenoberfläche aufliegt.

Die Folie soll so beschaffen sein, dass sie die Probe nicht zerkratzt. Es sollen z.B. keine Grate durch den Bearbeitungsprozess der Öffnungen mehr vorhanden sein. Die Probe soll so flexibel und elastisch sein, dass Unebenheiten (Verunreinigungen die sich auf der Probe befinden, Sägefehler, ..) der Probe ausgeglichen werden können ohne diesen zu beschädigen. Die Folie kann aus weichem Material wie z.B. Aluminium oder einem Polymermaterial gefertigt sein oder die Seite der Folie, die auf die Probe gedrückt wird, damit beschichtet sein. Ausserdem soll die Folie den verwendeten Ätzprozessen standhalten und kann deslialb auf der dem Plasma ausgesetzten Seite mit einer ätzresistenten Schicht beschichtet sein. Je nach verwendetem Ätzprozess muss das richtige Material ausgewählt werden. In Frage kommen z.B. SiO2, SiN, oder SiC.

Wichtig für Anspruch eins ist, dass, es möglichst nicht zu Unterätzungen oder Abscheidungen unter die Maske kommt und die Oberfläche der Probe nicht beschädigt wird.

Anstelle der Folie kann auch eine Maske verwendet werden. Diese kann auch wie oben beschrieben auf der einen Seite weich beschichtet sein oder aus einem weichen Material bestehen um die Probe nicht zu beschädigen. Auf der anderen Seite kann sie wie oben beschrieben mit einer Schicht beschichtet sein die für die erforderlichen Ätzprozesse resistent ist.

Die Maske liegt durch ihr Eigengewicht auf oder wird angedrückt um Unterätzungen zu unterbinden.

Die Spannkraft der Folie sowie die Andruckkraft der Folie auf die Probe bzw. die Andruckkraft der Maske sind so zu wählen, dass ein unterätzen vermieden wird und gleichzeitig die Probenoberfläche nicht geschädigt wird.

Auf die aufgelegte Maske, die auf der Oberflächenpassivierenden Schicht liegt, kann eine oder mehrere weitere Maske/n gelegt oder gespannt können werden, die einen Teil der Öffnungen der aufgelegten Maske abdeckt/en."

Dies ist dann erforderlich wenn voneinander verschieden aufgebaute Kontakte auf die selbe Probenseite aufgebracht werden sollen wie z.B. in Beispiel 3.2 der Rückkontäkt Solarzelle (HIT-BACK). Hier werden Emitter und Basiskontakt, beide auf der Probenrückseite abgeschieden. Die erste Maske bildet die Grundstruktur, wobei die zweite nur einen Teil dieser Struktur freigibt. Wird nach erfolgten Prozess wird die zweite Maske entfernt und durch eine dritte Maske ersetzt, die wiederum andere Teile der Grundstruktur freigibt. So können Teilbereiche der Probe die eigentlich durch die Grundstruktur freigegeben sind vor Prozessen für andere Kontakte geschützt werden. Es ist so möglich die erste Maske in Position zu halten ohne auf unterschiedliche Kontakttypen (p-Typ, n-Typ, nur Metallisierung, ...) auf der selben Probenseite zu verzichten. So können Rückkontaktsolarzellen mit Heterostrukturkontakten erstellt werden.

Die Oberflächenpassivierende Schicht kann auch als Antireflexschicht dienen oder einem Stapelförmigen Antireflex-Schichtaufbau angehören. Dementsprechend sind die Brechungsindizes und Schichtdicken anzupassen, was z.B. bei a-SiN:H mögliche ist.

Andererseits können an lokalen Kontakten in passivierenden Schichten, die den Feldeffekt nutzen, Verluste im Berührungsbereich Oberflächenpassivierung-Kontäkt auftreten [Dauwe02. Dies kann es sinnvoll machen auf der Kontaktseite solche Schichten nicht zu nuzten.

Sollen z.B. Rückkontaktsolarzellen erstellt werden ist es evtl. sinnvoll die Passivierung auf der Forderseite aus einem anderen Material (-stapel) zu fertigen als die Rückseite mit den, Kontakten.

Der Plasmaätzprozess ist so zu führen, dass er möglichst anisotrop und senkrecht zu Maskenoberfläche erfolgt. Dies lässt, sich durch die Prozessführung beeinflussen [Lengtenberg95]. Dadurch wird verhindert, dass unterhalb der Maske geätzt wird, was bei isotropem Ätzen geschehen würde. Bei dem folgenden Abscheideprozessen würde unter Umständen an den unterätzten Stellen nicht abgeschieden, was zu Wirkungsgradverlusten führt.

Beim Anisotropen Ätzen werden mitunter scharfe Kanten erzeugt, die zu Sollbruchstellen führen können. Um diese zu beseitigen können nach dem anisotropen Ätzprozess ein isotroper Ätzprozess folgen der die Kanten abrundet und so die Bruchneigung mindert.

Je nach verwendeter Gaszusammensetzung und Prozessführung können Ätzrückstände auf der geätzten Oberfläche verbleiben oder die Kristallstruktur des Substrates schädigen was sich negativ auf die Solarzelle auswirken kann. Diese Rückstände können durch eine geeignete Prozessführung vermieden werden, oder in einem oder mehreren anschliessenden Ätzschritten, die darauf abgestimmt sind, beseitigt werden.

Für die Erstellung der Solarzelle sollen möglichst wenige Prozesskammern verwendet werden, daher ist es günstig, wenn der Ätzprozess so gewählt wird, dass die Rückstände in der Kammer, verursacht durch einen vorherigen Abscheideprozess, dass diesen Rückstände mit beseitigt werden. Dieser Ätzprozess kann auch aus zwei oder mehreren Prozessen bestehen einer ätzt die Rückstände, der Nächste die Kontaktöffnung. Dies kann durch das selektive Ätzverhalten des Plasmas möglich sein.

Die Heterokontakte sollen elektrisch besser sein als diffundierte Kontakte. Dies ist z.B. durch den HIT-Aufbau von SANYO erreicht worden [Swanson05]. Ihre Sättigungsstromdichte ist mit 18 fA/cm2 40 mal geringer als die von diffundierten Kontakten [Swanson05]. Die Heterokontakte sollen so erstellt werden, dass möglichst auch diese oder niedrigere Werte errecht werden. Hierzu kommen verschiedene Schichten oder Schichtaufbauten in Frage, die z.B. in den Sanyo Patenten, DE3732617A1, DE4010302A2, DE4025311, DE4027236, US5213628, US5705828, EP1113505., US20010.008295, 6670542, JP20011894278, EP1187223A2, EP1300889A2, EP1320134, JP2003324209, US2003168578, JP002003258287, US20030168660A1 beschrieben sind, sich aber nur auf ganzflächige Schichtaufbauten beziehen wobei Emitter- oder Basiskontakt entweder zur Licht zu- oder abgewandten Seite gerichtet sind. Sie beziehen sich nicht auf lokale Kontakte und auch nicht auf Rückkontaktsölarzellen bei denen sich beide Solarzellenköntakte auf einer Pröbehseite befinden.

Es kommen auch andere Schichten oder Schichtaufbauten in Frage, die einfacher zu erstellen sind. Wenn z.B. auf den intrinsischen Bufferlayer verzichtet wird [Schmidt06], ein Basiskontakt mit znO verwendet wird [Rostan05], nanokristallines Silizium verwendet wird [Farrokh-B. 06]. Viele weitere sind möglich. Sie alle sollen möglichst geringe Verluste verursachen die den Solarzellenwirkungsgrad beeinträchtigen können.

Auch ist es möglich die letzten Verunreinigungen, wie in einem SANYO Patent für ganze Flächen beschrieben, mittels eines Wasserstoffplasmas, das auch mit einem Dotiergas versetzt sein kann oder nur aus einem Dotiergas besteht, zu beseitgen oder zu kompensieren.

Ausserdem ist es möglich, die abgeschiedenen Schichten, wie in einem SANYO Patent beschrieben, mit einem Wasserstoffplasma, gegebenenfalls mit Dotiergas, nachzubehandeln.

Wird auf die oberste Schicht eine oder mehrere Metallschichetn abgeschieden, so dient dies nicht nur der verbesserten internen Reflexion sondern kann auch als Kontaktfläche für Zellverbinder dienen.

TCOs sind üblicherweise n-Typ. Es sind auch p-Typ TCOs bekannt. N-Type TCO kann in Verbindung mit p-Typ Schichten zu Kontaktproblemen führen und dadurch zu Wirkungsgradverlusten führen. Deshalb ist es unter Umständen sinnvoll auf p-Typ und n-Typ Kontakte die entsprechenden TCOs getrennt abzuscheiden.

Wird als letzte Schicht eine hochleitfähige Schicht, z.B. TCO oder na-Si:H, abgeschieden, können die Zellverbinder mit elektrisch leitfähigen Klebern direkt auf die hochleitfähige Kontaktfläche geklebt werden. Das hat den Vorteil, dass auf Löten verzichtet werden kann. Kleben erfolgt in der Regel bei niedrigeren Temperaturen als Löten. Besonders wenn keine bleihaltigen Lote mehr verwendet werden dürfen steigt die Löttemperatur weiter. Zu hohe Temperaturen können die Heterokontakte schädigen. Ausserdem besteht beim Löten die Gefahr der Verspannung und des Biegens des Wafers, was bei niedrigen Klebetemperaturen geringer ausfällt.

Nach dem lokalen Öffnen der Oberflächenpassivierung kann die Probe einem Wasserstoffplasma ausgesetzt werden, um so in Sauerstoffreichem z.B. Czochalski-Silizium Thermische Donatoren zu erzeugen.

Thermische Donatoren können in Sauerstoff reichem Silizium mit Hilfe von Wasserstoff erzeugt werden. Setzt man eine Sauerstoff reiche Siliziumprobe, z.B. Standard-Czochalsky-Silizium (Sauerstoffanteil von ca. 10<18> cm<-3>), einem Wasserstoffplasma aus, so diffundiert der Wasserstoff in das Silizium. Es entsteht ein Wasserstoff-Konzentrationsgradient. Entlang dieses Gradienten formieren sich mehrere Sauerstoffatome zu Donatoren um (durch Tempern bei z.B. 450 deg. C; daher der Name ,Thermische Donatoren'). Die Dotierung geschieht roportional zu der Wasserstoffkonzentration. Es lässt sich so, abhängig von der Wasserstoffkonzentration, ein Dotiergradient erzeugen [Job98]. Die maximale Dichte an TD beträgt, abhängig von der Sauerstoffkonzentration im Silizium, etwa 3 X 10<16> cm<-3>. Dies genügt zur Umdotierung von p-Typ Material Mit Hilfe dieses Verfahrens lässt sich z.B. ein pn-Übergang erzeugen (Fig. [image - see original document] in [Huang04]). Bei höheren Temperaturen wie z.B. 550 deg. C lassen sich innerhalb von 20 min 300 [mu] m [mu] m tiefe Gradienten erzeugen.

Die Erzeugung von Dotiergradienten (auch ohne pn-Übergang) hat eine wesentlich verbesserte Einfangswahrscheinlichkeit für die Minoritäts-Ladungsträger zufolge (Fig. in Scherff06), da diese zu den Kontakten hin beschleunigt werden, sobald sie sich in dem Driftfeld (DF) befinden. In eigenen Versuchen ist eine Verdoppelung der effektiven Diffusionslänge bei Anwendung der TD zu beobachten, obwohl aufgrund der Wasserstoff-Plasmabehandlung (der verwendete Prozess war nicht für Solarzellen optimiert worden) eine Schädigung der Rückseite aufgetreten ist.

Dieses Verfahren wird schon in [Ulyashiw01] vorgeschlagen, allerdings nicht für lokale Driftfelder. Frage: Wie neuheitsschädlich ist das Paper einzustufen? Wie weit liesse sich das Verfahren der tiefen ganzflächigen Driftfelder trotz der Veröffentlichung von Ulyashin patentieren?

Erfolgt die Wasserstoffplasmabehandlung durch die oben beschriebene Maske, könnten so lokale Dotiergradienten (Driftfelder), ähnlich zu lokalen BSFs (Back Surface Field), wie in z.B. [Green98] erzeugt werden. Allerdings können diese BSFs in gleicher Zeit und bei niedrigeren Temperaturen wesentlich tiefer ins Substrat hineinragen. Dies hat dann eine deutlich verbesserte Einfangwahrscheinlichkeit für die Minoritäts-Ladungsträger, insbesondere für Substrate deren Diffusionslänge gross gegenüber der Waferdicke ist, zufolge, da diese zu den Kontakten hin beschleunigt werden, sobald sie sich in dem tiefen Driftfeld befinden. Bei Rückkontakt-Solarzellen können die Driftfelder lateral von den Emitter- zu den Basiskontakten wirken. Der Einfluss von Driftfeldern auf den Solarzellenwirkungsgrad wird in [Cuevas97] untersucht. Auch wenn die untersuchten Zellstrukturen verschieden von den hier beschriebenen Strukturen sind, ist festzuhalten, dass die Diffusionslänge in Richtung des Driftfeldes um Faktor 3 bis 10 erhöht wird, wenn ein Dotiergradient von einer bzw. zwei Grössenordnungen vorliegt. Um den gleichen Effekt durch Verwendung eines besseren Siliziummaterials zu erreichen, müsste Silizium mit einer verzehnfachen bzw. verhundertfachen Minorität-Träger-Lebensdauer verwendet werden.

Da durch Thermischen Donatoren maximal nur 3 10<16> cm<-3> Donatoren erzeugt werden können und für einen Dotiergradienten von ein bis zwei Grössenordnungen die Substratdotierung folglich bei 3 10<15> cm<3> bzw. 3 10<14> liegt, wird ein zusätzliches BSF erforderlich, um hinreichend hohes Built-In-Potential und dementsprechend hohe Leerlaufspannungen zu erhalten. In den Beispielen des Kapitel 3 bilden die hochdotierten amorphen Siliziumschichten des Rückkontaktes das BSF.

Es kann sein, dass z.B. Die Maske die Temperaturen zum Eindiffundieren des Wasserstoffes nicht standhält oder aufgrund unterschiedlicher Wärmeausdehnungskoeffizienten auf der Probe gleitet und diese dadurch beschädigt oder aus ihrer Position verrutscht. Deshalb kann es nützlich sein den Temperprozess zeitlich von dem Wasserstoffplasma zu trennen und auf einen späteren Zeitpunkt, z.B. wenn die Masken entfernt wurden, zu verlegen und dann erst zu tempern.

Ist das Wasserstoffplasma zu intensiv oder die Temperatur während des Wasserstoffplasmas zu niedrig, dann entstehen an den behandelten Kontaktstellen unterhalb der Substratoberflächen starke Kristallschäden. Diese sollten beseitigt werden, da es dort sonst zugerhöhter Rekombination kommen kann.

Diese Rekombination wird bei einem erzeugten Dotiergradienten allerdings schwächer ausfallen als ohne, da in dem geschädigten Bereich die unterschiedlichen Ladungsträgertypen schon durch das elektrische Feld weitestgehend voneinander getrennt wurden.

### Ausführungsbeispiel:

### Prozess für eine HIT-BACK Solarzelle

Beschrieben wird das Ausführungs-Beispiels zur Erstellung einer ***HIT-BACK*** Solarzelle (Rückkontakt-Solarzelle mit Hetero (HIT-)-Kontakten).Hier werden ausschließlich Plasmaprozesse verwendet. Ausgegangen wird von einem unbehandelten (sägerauen) Cz-Wafer in Standardqualität (L_{b} = 10 µs). Idealerweise erfolgen die Prozesse in Atmosphären-Druck CVD Anlagen (AP-CVD). Diese Art von CVD-Anlagen hat den Vorteil, dass keine Vakuumkammern und Pumpsysteme erforderlich sind (Kostenersparnis bei der Investition und Wartung). Außerdem entfallen die Zeiten zum Evakuieren. Geringere Ausfallzeiten sind wahrscheinlich (keine Pumpen, keine Lecks im Vakuumsystem). Das mit diesen Anlagen auch hervorragende Ergebnisse erzielbar sind, ist in [Imai06, Heintze06, Matsumoto03,] bewiesen worden.

| **Siehe Abbildung Nr.:** | Prozess | Bemerkung |
|---|---|---|
| 5 | Unbehandelter n-Type Cz-Wafer (1) (sägerau) | Günstiger mono-Silizium-Wafer (evtl. in Zukunft aus günstigem PV-Grade-Silizium gezogen) |
| 6 | Substratreinigung: | (100)-mono Si Wafer mit SF₆ in AP-CVD geätzt [Heinze06] |
| | Plasmaätzen des Sägeschadens (52) und Vorderseite texturieren (53) (SF₆ + O₂) [Schnell00] | |
| 7 | Passivierung der Wafervorderseite: | [Imai06] (Oberflächenrekombinationsgeschwindigkeiten von 100 cm/sec wurden erreicht) |
| | Passivierung (21) mittels Plasmaprozess abscheiden | |
| | | Liegt der Wafer frei (z.B. auf einem beheizten Carrier) erfolgt die Abscheidung auch an den Waferkanten und passiviert diese. |
| | z.B. 30 nm | |
| 8 | Doppelschicht ARC Erste Schicht (31) mit Brechungsindex n ~ 2.3 | |
| | Zweite Schicht (32) mit Brechungsindex n ~ 1,5 | |
| | z.B. a-SiN:H | |
| 9 | Substratreinigung: | [Heinze06] |
| | Plasmaätzen des Sägeschadens (52) auf der Rückseite | |
| 10 | Passivierung der Waferrückseite: | [Imai06] |
| | Passivierung (22)mittels Plasmaprozess abscheiden | |
| | z.B. [Imai06] | |
| | z.B. 30 nm | |
| 11 | Erstellung des Basiskontaktes | |
| | (BSF) | |
| | (Masken auflegen): | |
| | Die Ur- Maske 1 (42) + | |
| | Maske 2 (43) für den Basiskontakt auflegen | |
| 12 | Erstellung des Basiskontaktes | [Legtenberg95] |
| | (BSF) | |
| | (Ätzen): | |
| | Passivierung (22) | |
| | lokal öffnen (Plasmaätzen (51)) | |
| 13 | Erstellung des Driftfeldes (6) | [Job98] und Ref. 1,2 und 3 daraus |
| | (Wasserstoff einbringen): | |
| | Wasserstoffplasma (61) bei 450 °C | |
| | Ein Gradient von Thermischen Donatoren (62) entsteht und erzeugt tiefes Driftfeld (6) | |
| 14 | Erstellung des Basiskontaktes (71) | Der Rückkontakt kann auch aus einen |
| | (BSF) | |
| | (Plasmaabscheidung): | Schichtaufbau, wie bei der HIT-Solarzelle von SANYO, mit intrinsischem Buffer-Layer |
| | Rückkontakt abscheiden | (i)a-Si:H/(n)a-Si:H oder (i)a-Si:H/(n)a-Si:H/(n⁺)µ c-Si mit hochdotierter mikrokristalliner Siliziumschicht bestehen. |
| | 2. (n) a-Si:H BSFschicht | |
| 15 | Erstellung des Emitterkontaktes (pn-Junktion) | |
| | (Masken auflegen): | |
| | Maske 2 (43) für den Basiskontakt entfernen + | |
| | Maske 3 (44) für den Emitter auflegen, | |
| 16 | Erstellung des Emitterkontaktes (pn-Junktion) | [Legtenberg95] |
| | (Plasmaabscheidung) | |
| | Passivierung (21) | |
| | lokal öffnen (Plasmaätzen (51)) | |
| 17 | Erstellung des Emitterkontaktes (pn-Junktion) | |
| | Emitterkontakt abscheiden | |
| | (p) a-Si : H Emitterschicht (72) | |
| 18 | Emitterkontakt fertiggestellt | Beide Kontaktflächen sind geöffnet und können gleichzeitig bearbeitet werden. |
| | Maske 3 (44) für den Emitter entfernen | |
| 19 | Erstellung der Kontaktflächen | Das TCO (81) bildet den Kontakt und wirkt als Antireflexschicht. |
| | Optional | |
| | (TCO (81) aufsputtern): | Auf das TCO (81) können anschließend Metalle aufgebracht werden oder direkt Zellverbinder aufgeklebt werden. |
| | TCO Schicht aufsputtern | Je nach Zellaufbau kann auf das TCO aber auch verzichtet werden. |
| 20 | Fertige Solarzelle | Je nach verwendeter Passivierungsschicht (22) ist die Rückseite der HIT-BACK- Solarzelle komplett Transparent. |
| 21 | Bifaciale Solarzelle | Schmale Metallisierung kann aufgebracht werden. Durch Aufdampfen, |
| | | Siebdruck [Windgassen05] (wie am Emitterkontakt Abb. Link s (95)) oder durch Aufkleben von dünnen Drähten (wie am Basiskontakt Abb. Rechts (94)). |
| | | |
| 22 | HIT-BACK Solarzelle mit aufgeklebten Zellverbindern (93) | Zellverbinder können direkt auf die TCO (81) Schichten geklebt werden. |
| 23 | HIT-BACK Solarzellen durch aufgeklebten Zellverbinder (93) verbunden | Durch das Verkleben wird die Metallisierung (95) bzw. (94) eingespart. |

### Literatur:

- [Breitenstein06]: O. Breitenstein, P. Altermatt, K. Ramspeck, M.A. Green, Jianhua Zhao und A. Schenk, Interpretation of the Commonly Observed I-V Characteristics of c-Si Cells Having Ideality Factor Larger than Two, Proc. 4th WCPEC, Hawaii, 879-884, (2006).
- [Dauwe02]: S. Dauwe, L. Mittelstädt, A. Metz, und R. Hetzel, Experimental Evidence of Parasitic Shunting in Silicon Nitride Rear Surface Passivated Solar cells, Prog. Photovolt: Res. Appl., 10, 271 (2002).
- [Farrokh-B.06]: M. Farrokh Baroughi und S. Sivoththaman, A Novel Si-based Hetero-junction Solar Cell without Transparent Conductive Oxide, Proc. 4th WCPEC, Hawaii, 83-86, (2006).
- [Goetzberger03]: A. Goetzberger, C. Hebling und H.-W. Schock, Photovoltaic materials, history, status and outlook, Mater. Sci. Eng. R 40, 1 (2003).
- [Glunz02]: S.W. Glunz, J.Dicker, M. Esterle, M. Hermle, J. Isenberg, F.J. Kamerewerd, u. A., High-Efficiency Silicon Solar Cells for Low-Illumination Applications, Proc. 29th PVSC, New Orleans, 450, (2002).
- [Glunz04]: S. Glunz, E. Schneiderlöchner, D. Kray, A. Grohe, M. Hermle, H. Kampwerth, R. Preu und G. Willecke, Laser-Fired Contact Silicon Solar Cells on p- and n-Substrates, Proc. 19th Europ. PVSEC, Paris, (2004)
- [Glunz06]: S. W. Glunz, S. Janz, M. Hofmann, T. Roth und G. Willeke, Surface Passivation of Silicon Solar Cells using Amorphous Silicon Carbide Layers, Proc. 4th WCPEC, Hawaii, 1016-1019, (2006).
- [Green98]: M. Green, J. Zhao, A. Wang, 23 % Module and other Silicon Solar Cell Advances, Proc. 2nd WCPEC, Wien, 1187, (1998)
- [Heintze06]: M. Heintze, A. Hauser, R. Möller, H. Wanka, E. López, I. Dani, V. Hopfe, J.W. Müller, A. Huwe, In-Line Plasma Etching at Atmospheric Pressure for Edge Isolation in Crystalline Si Solar Cells, Proc. 4th WCPEC, Hawaii, 1119-1121, (2006).
- [Huang04]: Y. L. Huang, Y. Ma, R. Job, A. G. Ulyashin, Hydrogen diffusion at moderate temperatures in p-type Czochralski silicon, Journal of Applied Physics 96 (12), 7080-7086, (2004),
- [Huang05]: Y. L. Huang, Y. Ma, R. Job, M. Scherff, W. R. Fahrner, H. G. Shi, D. S. Xue and M.-L. Davidc, Silicon Pyramidal Texture Formed in Pure Hydrogen Plasma Exposure, Journal of The Electrochemical Society, 152 (9), C600-C604, (2005).
- [Imai06]: R. Imai, T Ishiwata, H Si, N Yamamotö, K Arafune, Y Ohshita and M Yamaguchi, Surface Passivation of crystalline Silicon Solar Cells by Atmospheric Pressure chemical Vapour Deposition, Proc. 4th WCPEC, Hawaii, (2006).
- [Jansen95]: H. Jansen, M. de Boer, R. Legtenberg und M. Elwenspoek, The Black Silicon Method:, J. Micromech. Microeng. (5), 115 (1995).
- [Jensen02b]: N. Jensen, Heterostruktursolarzellen aus amorphem und krisallinem Silicium, Dissertation, (Shaker Verlag GmbH, Aachen, 2002).
- [Jin06]: H. Jin, K.J.Weber und A.W.Blakers, Depassivation of Si-SiO2 Interface Following Rapide Thermal Annealing, Proc. 4th WCPEC, Hawaii, 1078-1080, (2006).
- [Jin06b]: H. Jin, K.J.Weber und A.W.Blakers, The Effect of a Post Oxidation In-situ Nitrogen Annual on Si Surface Passivation, Proc. 4th WCPEC, Hawaii, 1071-1073, (2006).
- [Job98]: R. Job, W.R. Fahrner, N. M. Kazuchits, A. G. Ulyashin, A Two Step Low-Temperature Process for a p-n Junction Formation due to Hydrogen enhanced Thermal Donor Formation in p-Type Cz Silicon, MRS 513 ,337, (1998).
- [Legtenberg95]: R. Legtenberg, H. Jansen, M. de Boer und M Elwenspoek, Anisotropic Reactive Ion Etching of Silicon Using SF6/02/CHF3 Gas Mixtures, J. Electrochem. Soc., 142,2020 (1995)
- [Lim98]: S.-H. Lim, J.-W. Park, H.-K. Yuh und E. Yoon, Dry Cleaning of Fluorocarbon Residuals by Low-Power Electron Cyclotron Resonance Hydrogen Plasma, Journal of the Korean Physical Society, (33), 108, (1998),
- [Maruyama06]: E. Maruyama, A. Terakawa, M. Taguchi, Y. Yoshimine, D. Ide, T. Baba, M. Shima, H. Sakata und M. Tanaka, Sanyo's Challenges to Development of High-efficiency HIT Solar Cells and Expansion of HIT Business, Proc. 4th WCPEC, Hawaii, 1455-1460, (2006).
- [Matsumoto03]: M. Matsumoto, M. Shima, S. Okamoto, K. Murata2, M. Tanaka, S. Kiyama, H. Kakiuchi, K. Yasutake, K. Yoshii , K. Endo und Y. Mori, Extremely High-Rate Deposition of Silicon Thin Filmes Pr epared By Atmospheric Plasma CVD Methode with a Rotary Electrode, Proc. 3rd WCPEC, Osaka, 50-A3-03,(2003).
- [Mulligan04] W.: Mulligan, D. Rose, M. Cudzinovic, D. DeCeuster, K.McIntosh, D. Smith, and R. Swanson. Manufacture of Solar Cells with 21 % Efficiency, Proc. 19th Europ. PVSEC, Paris, (2004).
- [Plagwitz05]: H. Plagwitz, M. Schaper, A.Wolf, R. Meyer, J. Schmidt, B. Terheiden und R. Brendel, 20%-Efficient silicon Solar Cells with Local Contacts to the a-Si-Passivated Surfaces by means of Annealing (COSIMA), Proc. 20th Europ. PVSEC, Barcelona, 725 (2005).
- [Sopori06]: B. Sopori, R. Reedy, K. Jones, L. Gedvilas, B. Keyes, Y. Yan, M. Al-Jassim, V. Yulundur und A. Rohatgi, Damage-Layer-Mediated H Diffusion During Si: H Processing: A Comprehensive Model, Proc. 4th WCPEC, Hawaii, 1028-1031, (2006).
- [Scherff06]: M. L.D. Scherff, S. Schwertheim, Y. Ma, T. Mueller, W. R. Fahrner, 10 × 10 cm2 HIT Solar Cells Contacted with Lead-Free Electrical Conductive Adhesives to Solar Cell Interconnectors, Proc. 4th WCPEC, Hawaii, 1384-1387, (2006).
- [Scherff06a]: M.L.D. Scherff and Y. Ma and W. Düngen. and T. Mueller and W.R. Fahrner, Increased efficiencies in a-Si:H(n) / cz-Si(p) heterojunction solar cells due to gradient doping by thermal donors, 21th Europ. PVSEC, Dresden, 1178-1180 (2006).
- [Scherff06b]: M.L.D. Scherff, H. Stiebig, S. Schwertheim und W.R. Fahrner, Double Layer Antireflection Coating of Heterojunction Solar Cells, 21th Europ. PVSEC, Dresden, 1392-1395, (2006).
- [Schmidt06]: M. Schmidt, H. Angermann, E. Conrad, L. Korte, A. Laades, K.v. Maydell, Ch. Schubert und R. Stangl, Physical and Technological Aspects of a-Si:H/c-Si Hetero-Junction Solar Cells, Proc. 4th WCPEC, Hawaii, 1433-1438, (2006).
- [Schnel100]: M. Schnell, R. Lüdemann und S. Schaefer, PLASMA. SURFACE TEXTURIZATION FOR MULTICRYSTALLINE SILICON SOLAR CELLS, Proc. 28th PVSC, Ankorage, 367 (2000).
- [SP-22006]: Data sheet Sunpower SPR-220 www.sunpowercorp.com (Juni 2006).
- [Stangl01]: R. Stangl, A. Froitzheim, L. Elstner und W. Fuhs, Amorphous/chrystalline silicon heterojunction solar cells, a Simulation study, Proc. 17th Europ. PVSEC, München, 1387-1390, (2003).
- [Stangl03]: R. Stangl, A. Froitzheim, M. Schmidt und W. Fuhs, Design Criteria for Amorphous/Cristalline Silicon Heterojunction Solar Cells, - A Simulation Study, Proc. 3rd WCPEC, Osaka, 4P-A8-45, (2003).
- [Swanson05]: R. Swanson, Approaching the 29 % Limit Efficiency of silicon Solar Cells, Proc. 31th PVSC, Colorado Springs, 889 (2005).
- [Taguchi05]: M. Taguchi, H. Sakata, Y. Yoshimine, E. Maruyama, A. Terakawa and M. Tanaka, An Approche for the higher Efficiency in the HIT Cells, Proc. 31th PVSC, Colorado Springs, 866 (2005).
- [Tucci01]: M. Tucci, R. De Rosa und F. Roca, CF4/O2 Dry Etching of Textured Crystalline Silicon Surface in a-Si:H/c-Si Heterojunction for Photovoltaic Applications, Sol. Energy Mater. Sol. Cells, 69, 175 (2001).
- [Ulyashin01]: A. Ulyashin, R. Job, M. Scherff, W. R. Fahrner,: Low-temperature drift field performance in the base region of crystalline silicon solar cells by hydrogen enhanced thermal donar formatation, 17th European PVSEC, München, 1379 (2001),
- [vanWiering.56]: A. Van Wieringen and N. Warmholtz, Physica, 22, 849 (1956).
- [Windgassen05]: H. Windgassen, M.Scherff, A. Nositschka, H. Kurz und W.R. Fahrner, Large Area (n)a-Si:H/(p)c-Si Heterojunction Solar Cells with Low Temperature Screen Printed Contacts, Proc. 20th Europ. PVSEC, Barcelona, 954 (2005).
- [Wieringen56]: A. Van Wieringen und N. Warmholtz, Physica 22, 849 (1956).
- [Weber97]: K.J. Weber, A. Cuevas und A. W. Blakers, The Influence of Drift Fields in Thin Silicon Solar Cells, Sol. Energy Mater. Sol. Cells, 45, 151 (1997).
- [Zhang00]: D. ZHANG, Promotionsschrift: Surface reaction Mechanisms in Plasma Etching Processes, University of Illinois at Urbana-Champaign, Urbana, Illinois, 2000.

## Patentansprüche

1. Solarzellen-Herstellungsverfahren, bei dem lokale Heterokontakte erzeugt werden, **dadurch gekennzeichnet, dass** auf einem oberflächenpassivierten Halbleitermaterialeine oberflächen - passivierende Schicht des Halbleitermaterials, lokal, durch Öffnungen einer aufgelegten Maske, mittels Plasmaätzen geöffnet wird und die aufgelegte Maske anschließend als Maskierung für weitere Abscheideprozesse von Heterokontakten verwendet wird.

2. Solarzellen-Herstellungsverfahren, bei dem lokale Heterokontakte erzeugt werden, **dadurch gekennzeichnet, dass** auf einem oberflächenpassivierten Halbleitermaterialeine oberflächen-passivierende Schicht des Halbleitermaterials, lokal, durch Öffnungen einer aufgespannten Folie, mittels Plasmaätzen geöffnet wird und die aufgespannte Folie anschließend als Maskierung für weitere Abscheideprozesse von Heterokontakten verwendet wird.

3. Verfahren nach Anspruch 1, **dadurch gekennzeichnet, dass** die aufgelegte Maske als Maskierung für weitere Abscheideprozesse umfassend TCO-Abscheidung und / oder Metallabscheidung und/oder für weitere Plasmaprozesse verwendet wird.

4. Verfahren nach Anspruch 1 oder 3, **dadurch gekennzeichnet, dass** die aufgelegte Maske derart eng aufgelegt wird, dass Unterätzungen oder Abscheidungen unter der Maskierung vermieden werden.

5. Verfahren nach Anspruch 1, 3 oder 4, **dadurch gekennzeichnet, dass** auf die aufgelegte Maske, die auf der Oberflächenpassivierenden Schicht liegt, eine oder mehrere weitere Maske/n gelegt oder gespannt wird/werden, die einen Teil der Öffnungen der aufgelegten Maske abdeckt/en.

6. Verfahren nach einem der vorangehenden Ansprüche, **dadurch gekennzeichnet, dass** die passivierende Schicht auf der Solarzellenvorderseite aus einem anderen Material oder einer anderen Materialschichtung besteht, als die der Rückseite.

7. Verfahren nach einem der vorangehenden Ansprüche, **dadurch gekennzeichnet, dass** im Wesentlichen nur die Oberflächen passivierende Schicht weggeätzt wird und dort keine Plasmarückstände und/oder Schädigungen des Substratmaterials hinterlässt.

8. Verfahren nach einem der vorangehenden Ansprüche, **dadurch gekennzeichnet, dass** der Plasmaätzprozess so gewählt wird, dass Plasmarückstände von vorherigen Abscheideprozessen mit beseitigt werden.

9. Verfahren nach einem der vorangehenden Ansprüche, **dadurch gekennzeichnet, dass** die Heterokontakte für Licht transparent sind.

10. Verfahren nach einem der vorangehenden Ansprüche, **dadurch gekennzeichnet, dass** auf die Heterokontakte als letzte Schicht eine oder mehrere Metallschichten aufgebracht werden.

11. Verfahren nach einem der vorangehenden Ansprüche, **dadurch gekennzeichnet, dass** auf unterschiedliche Heterokontakte (Emitter- bzw. Basis-Kontakt) unterschiedliche TCO-Schichten aufgebracht werden.

12. Verfahren nach einem der vorangehenden Ansprüche, **dadurch gekennzeichnet, dass** Zellverbinder direkt mit elektrisch leitfähigen Klebern auf das TCO geklebt werden.

13. Verfahren nach einem der vorangehenden Ansprüche, **dadurch gekennzeichnet, dass** nach dem Öffnen der Oberflächenpassivierung die spätere Kontaktregion einem Wasserstoffplasma ausgesetzt wird und gleichzeitig auf eine Temperatur zwischen 200°C und 800°C, besser zwischen 300°C und 600°C erwärmt wird.

14. Verfahren nach Anspruch 13, **dadurch gekennzeichnet, dass** das Wasserstoffplasma in einem ersten Schritt erfolgt und das Tempern zu einem späteren Prozesszeitpunkt.

15. Verfahren nach Anspruch 14, **dadurch gekennzeichnet, dass** ein entstandener Plasmaschaden des Substrates, hervorgerufen durch das Wasserstoffplasma, mittels eines oder mehrerer Plasmaätzprozesse beseitigt wird.

## Claims

1. Solar cell manufacturing process in which local heterojunctions are produced, **characterised in that** a surface-passivating layer of the semiconductor material on a surface-passivated semiconductor material is opened locally through openings in an applied mask by means of plasma etching, whereby the applied mask is used as masking for further deposition processes of heterojunctions.

2. Solar cell manufacturing process in which local heterojunctions are produced, **characterised in that** a surface-passivating layer of the semiconductor material on a surface-passivated semiconductor material is opened locally through openings in a stretched film by means of plasma etching, whereby the stretched film is used as masking for further deposition processes of heterojunctions.

3. Process according to claim 1, **characterised in that** the applied mask is used as masking for further deposition processes including TCO deposition and/or metal deposition and/or for other plasma processes.

4. Process according to claim 1 or 3, **characterised in that** the applied mask is so closely applied that under-etching or deposition is avoided under the masking.

5. Process according to claim 1, 3 or 4, **characterised in that** one or more additional masks are laid or stretched on the applied mask, lying on the surface-passivating layer, in order to cover part of the openings of the applied mask(s).

6. Process according to any one of the preceding claims, **characterised in that** the surface-passivating layer on the solar cell comprises a different material or a different material layer on the front side than that on the rear side.

7. Process according to any one of the preceding claims; **characterised in that** substantially only the surface-passivating layer is etched away leaving no plasma residues and/or damage to the substrate material.

8. Process according to one of the preceding claims, **characterised in that** the plasma etching process is so selected that plasma residues of previous deposition processes are eliminated with it.

9. Process according to any preceding claim, **characterised in that** the heterojunctions are transparent to light.

10. Process according to any one of the preceding claims, **characterised in that** one or a plurality of metal layers are applied as the final layer to the heterojunctions.

11. Process according to any one of the preceding claims, **characterised in that** different TCO layers are applied on different heterojunctions (emitter and base-contact respectively).

12. Process according to one of the preceding claims, **characterised in that** cell connectors are directly bonded to the TCO by electrically-conductive adhesives.

13. Process according to any one of the preceding claims, **characterised in that** after opening the surface passivation, the subsequent contact region is exposed to a hydrogen plasma and simultaneously heated to a temperature between 200°C and 800°C, better between 300°C and 600°C.

14. Process according to claim 13, **characterised in that** the hydrogen plasma etching is carried out in a first step and the tempering process at a later point in the process.

15. Process according to claim 14, **characterised in that** any plasma damage to the substrate caused by the hydrogen plasma etching is eliminated by means of one or more plasma etching processes.

## Revendications

1. Procédé de fabrication de cellules photovoltaïques, dans lequel des hétérocontacts locaux sont formés, **caractérisé en ce que**, sur un matériau semi-conducteur à surface passivée, une couche de passivation de surface du matériau semi-conducteur est ouverte localement à travers des ouvertures d'un masque appliqué à l'aide d'une gravure au plasma, et le masque appliqué est ensuite utilisé en tant que masque pour d'autres processus de déposition d'hétéro-contacts.

2. Procédé de fabrication de cellules photovoltaïques, dans lequel des hétérocontacts locaux sont formés, **caractérisé en ce que**, sur un matériau semi-conducteur à surface passivée, une couche de passivation de surface du matériau semi-conducteur est ouverte localement à travers des ouvertures d'un film tendu à l'aide d'une gravure au plasma, et le film tendu est ensuite utilisé en tant que masque d'autres processus de déposition d'hétéro-contacts.

3. Procédé selon la revendication 1, **caractérisé en ce que** le masque appliqué est utilisé pour masquer d'autres processus de déposition, y compris la déposition TCO et/ou la déposition métallique et/ou d'autres processus au plasma.

4. Procédé selon la revendication 1 ou 3, **caractérisé en ce que** le masque appliqué est appliqué de manière étroite de façon à éviter des gravures sous-jacentes ou des séparations sous le masquage.

5. Procédé selon la revendication 1, 3 ou 4, **caractérisé en ce que** sur le masque appliqué, qui repose sur la couche à passivation de surface, un ou plusieurs masque(s) est/sont posé(s) ou tendu(s), qui recouvre(nt) une partie des ouvertures du masque appliqué.

6. Procédé selon l'une des revendications précédentes, **caractérisé en ce que** la couche de passivation sur le côté avant de la cellule photovoltaïque est constituée d'un matériau ou d'un revêtement de matériau différent du côté arrière.

7. Procédé selon l'une des revendications précédentes, **caractérisé en ce que**, substantiellement seule la couche de passivation de surface est gravée et ne laisse aucun résidu de plasma et/ou dommage sur le matériau de substrat.

8. Procédé selon l'une des revendications précédentes, **caractérisé en ce que** le processus de gravure au plasma est choisi de façon à ce que les résidus de plasma des processus de séparation précédents soient éliminés.

9. Procédé selon l'une des revendications précédentes, **caractérisé en ce que** les hétérocontacts sont transparents à la lumière.

10. Procédé selon l'une des revendications précédentes, **caractérisé en ce que**, sur les hétérocontacts, sont appliquées, en tant que dernière couche, une ou plusieurs couches métalliques.

11. Procédé selon l'une des revendications précédentes, **caractérisé en ce que**, sur les différents hétérocontacts (contact d'émetteur ou de base), sont appliquées différentes couches TCO.

12. Procédé selon l'une des revendications précédentes, **caractérisé en ce que** des connecteurs de cellules sont collés directement sur le TCO à l'aide de colles électro-conductrices.

13. Procédé selon l'une des revendications précédentes, **caractérisé en ce que**, après l'ouverture de la passivation de surface, la région de contact successive est exposée à un plasma d'hydrogène et simultanément chauffée à une température entre 200°C et 800°C, mieux entre 300° C et 600°C.

14. Procédé selon la revendication 13, **caractérisé en ce que** le plasma d'hydrogène a lieu dans une première étape et le recuit à un stade ultérieur du processus.

15. Procédé selon la revendication 14, **caractérisé en ce qu'**un endommagement du substrat, provoqué par le plasma d'hydrogène, est éliminé à l'aide d'un ou plusieurs processus de gravure au plasma.
